# EUROPEAN PATENT SPECIFICATION

(11) **EP 4 682 625 B1**
(45) Date of publication and mention of the grant of the patent: **09.12.2026**
(21) Application number: 25190243.3
(22) Date of filing: 17.07.2025
(51) Int. Cl.: G02F 1/1345, G09G 3/32, H10W 72/00

(54) **DRIVING CHIP, DISPLAY DEVICE INCLUDING THE SAME, AND ELECTRONIC DEVICE INCLUDING THE SAME**
ANSTEUERUNGSCHIP, ANZEIGEVORRICHTUNG DAMIT UND ELEKTRONISCHE VORRICHTUNG DAMIT
PUCE DE COMMANDE, DISPOSITIF D'AFFICHAGE LA COMPRENANT ET DISPOSITIF ÉLECTRONIQUE LA COMPRENANT

(30) Priority: 18.07.2024 KR 20240094867
(43) Date of publication of application: 21.01.2026
(73) Proprietor: Samsung Display Co., Ltd., Yongin-si, Gyeonggi-do 17113 (KR)
(72) Inventor: Ko, Heewon, Yongin-si, Gyeonggi-do (KR)
(74) Representative: Gulde & Partner

(56) References cited:
- US-A1- 2020 355 972
- US-A1- 20240 072 224
- US-B2- 11 636 786
- US-B2- 7 450 393

## Description

### 1. Technical Field

Embodiments are directed to a driving chip and a display device including the same. More particularly, embodiments are directed to a driving chip for a display device capable of reducing manufacturing cost and a display device including the same.

### 2. Discussion of Related Art

Flat panel displays are thin, lightweight screens used in various electronic devices, like TVs, monitors, and smartphones. Unlike traditional cathode-ray tube (CRT) displays, flat panels use modern technology such as liquid crystal displays (LCDs), organic light-emitting diodes (OLEDs), or plasma to produce images with high resolution and clarity. They are known for their slim design, energy efficiency, and ability to deliver vivid colors and sharp visuals in a compact form factor.

Flat panel displays, such as LCDs and OLEDs, require precise and reliable signal transmission to ensure high-quality image rendering. However, traditional driving chip designs face several challenges that impact manufacturing cost, signal integrity, and defect prevention. One major issue is high manufacturing costs, as conventional designs demand larger chips and complex pad layouts, increasing production expenses. Additionally, signal reliability problems arise due to variations in voltage differences between adjacent control signals, leading to open defects and signal transmission failures. Misalignment between control output pads and bumps further contributes to defects, affecting display performance. Conventional driving chips also struggle with inefficient space utilization, requiring larger panel sizes to accommodate uniform pad distributions. Moreover, voltage inconsistencies in traditional designs increase the risk of electrical disconnections, reducing device reliability. Lastly, existing driving chip configurations often lack compatibility with flexible displays, making them less adaptable for next-generation devices.

Thus, there is a need for a cost-effective driving chip design that optimizes signal transmission, reduces manufacturing complexity, and enhances the reliability of flat panel displays without increasing chip size.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention. Relevant background art is disclosed in US 2024/072224 A1, US 11 636 786 B2, US 2020/355972 A1, and US 7 450 393 B2.

### SUMMARY

Embodiments provide a driving chip, a display device including the driving chip, and an electronic device including the display device, which may reduce manufacturing costs.

A display device according to an embodiment includes a substrate including a display area and a non-display area and including a pad area located on one side of the display area; pixels arranged in the display area; a driver circuit arranged in the non-display area; a driving chip overlapping the pad area and configured to generate data voltages for the pixels and control signals for the driver circuit; data output pads arranged in the pad area and each being configured to receive one of the data voltages; and control output pads arranged in the pad area and each being configured to receive one of the control signals. The number of the control output pads configured to receive a first control signal among the control signals is different from the number of the control output pads configured to receive a second control signal among the control signals.

In an embodiment, the display device may further include dummy pads that may be arranged in the pad area, that may be adjacent to the control output pads, and that may be electrically floated.

In an embodiment, the control output pads and the dummy pads may be arranged in a plurality of rows and a plurality of columns. The number of the control output pads arranged in a first row closest to the display area among the plurality of rows may be different from the number of the control output pads arranged in a n-th row among the plurality of rows, where n is a natural number greater than or equal to 2.

In an embodiment, the number of the control output pads arranged in the first row may be greater than the number of the control output pads arranged in the n-th row.

In an embodiment, the number of the dummy pads arranged in the first row may be different from the number of the dummy pads arranged in the n-th row.

In an embodiment, the number of the dummy pads arranged in the first row may be less than the number of the dummy pads arranged in the n-th row.

In an embodiment, the display device may further include control signal lines that may be electrically connected to the control output pads arranged in the first row, respectively. Each of the control signal lines may be electrically connected to the driver circuit.

In an embodiment, the control output pads arranged in each of the plurality of columns may be electrically connected to each other.

In an embodiment, the number of the control output pads arranged in a k-th column among the plurality of columns may be different from the number of the control output pads arranged in a p-th column among the plurality of columns, where k is a natural number greater than or equal to 2 and p is a natural number greater than or equal to 3 and is different from k.

In an embodiment, the control output pads arranged in a (k-1)-th column may be configured to receive a (k-1)-th control signal. The control output pads arranged in the k-th column may be configured to receive a k-th control signal. The control output pads arranged in a (k+1)-th column may be configured to receive a (k+1)-th control signal. The control output pads arranged in a (p-1)-th column may be configured to receive a (p-1)-th control signal. The control output pads arranged in the p-th column may be configured to receive a p-th control signal. The control output pads arranged in a (p+1)-th column may be configured to receive a (p+1)-th control signal. A sum of an electric potential difference between the (k-1)-th control signal and the k-th control signal and an electric potential difference between the k-th control signal and the (k+1)-th control signal may be greater than a sum of an electric potential difference between the (p-1)-th control signal and the p-th control signal and an electric potential difference between the p-th control signal and the (p+1)-th control signal. The number of the control output pads arranged in the k-th column may be greater than the number of the control output pads arranged in the p-th column.

In an embodiment, the number of the control output pads configured to receive the k-th control signal may be greater than the number of the control output pads configured to receive p-th control signal.

In an embodiment, the number of the dummy pads arranged in the k-th column may be less than the number of the dummy pads arranged in the p-th column.

In an embodiment, a sum of the number of the control output pads arranged in the k-th column and the number of the dummy pads arranged in the k-th column may be equal to a sum of the number of the control output pads arranged in the p-th column and the number of the dummy pads arranged in the p-th column.

In an embodiment, in each of the plurality of columns, at least one (or all) of the dummy pads may be spaced apart from the display area with at least one (or all) of the control output pads interposed therebetween.

In an embodiment, in a plan view, the outermost control output pads in each of the plurality of columns are arranged in a zigzag pattern in a plan view. Each of the outermost control output pads may be the control output pad positioned farthest from the display area within its respective column.

In an embodiment, the driving chip may include data output bumps respectively overlapping the data output pads and respectively electrically connected to the data output pads; may further include control output bumps respectively overlapping the control output pads and that may be respectively electrically connected to the control output pads; and may further include floating dummy bumps respectively overlapping the dummy pads and electrically floated.

In an embodiment, the display device may further include an anisotropic conductive film arranged between the control output pads and the control output bumps, and that may be respectively electrically connecting the control output pads and the control output bumps.

A driving chip according to an embodiment includes a base layer; data output bumps arranged on one surface of the base layer and each being configured to transfer one of a plurality of data voltages; and control output bumps arranged on the one surface of the base layer and each being configured to transfer one of a plurality of control signals. The number of the control output bumps configured to transfer a first control signal among the control signals is different from the number of the control output bumps configured to transfer a second control signal among the control signals.

In an embodiment, the driving chip may further include dummy bumps arranged on the one surface of the base layer, that may be adjacent to the control output bumps, and that may be electrically floated.

In an embodiment, the control output bumps and the dummy bumps may be arranged in a plurality of rows and a plurality of columns. The control output bumps arranged in each of the plurality of columns may be electrically connected to each other.

An electronic device according to an embodiment includes a display device configured to display an image; and a power supply configured to provide a power to the display device. The display device includes a substrate including a display area and a non-display area including a pad area located on one side of the display area; pixels arranged in the display area; a driver circuit arranged in the non-display area; a driving chip overlapping the pad area and configured to generate data voltages for the pixels and control signals for the driver circuit; data output pads arranged in the pad area and each being configured to receive one of the data voltages; and control output pads arranged in the pad area and each being configured to receive one of the control signals. The number of the control output pads configured to receive a first control signal among the control signals is different from the number of the control output pads configured to receive a second control signal among the control signals.

In an embodiment, a display device may include a plurality of control output pads arranged in a triangular configuration within a pad area adjacent to the display area. The control output pads may be structured across multiple rows and columns, with the number of control output pads decreasing as the rows extend farther from the display area. In this arrangement, a first row closest to the display area may include a greater number of control output pads, while a second row has multiple sets of control output pads, each separated by at least one dummy pad. A third row, positioned farther from the display area, may contain fewer control output pads, with each pad spaced apart by multiple dummy pads. In a fourth row, located even farther from the display area, individual control output pads may be further separated by multiple sets of dummy pads, that may form distinct triangular groupings of control output pads when viewed in a plan view.

According to embodiments, a reliability of the display device may be increased without increasing a size of the driving chip. Therefore, the manufacturing cost of the driving chip and the display device may be reduced.

### BRIEF DESCRIPTION OF THE DRAWINGS

The above and other features of embodiments of the present inventive concept will become more apparent by describing in detailed embodiments thereof with reference to the accompanying drawings, in which:
FIG. 1 is a plan view illustrating a display device according to an embodiment;
FIG. 2 is a cross-sectional view taken along line I-I' of FIG. 1;
FIG. 3 is a cross-sectional view taken along line II-II' of FIG. 1;
FIG. 4 is an enlarged plan view illustrating an example of area B of FIG. 2;
FIGS. 5 to 7 are enlarged plan views illustrating an example of area A of FIG. 1;
FIG. 8 is a cross-sectional view taken along line III-III' of FIG. 7;
FIGS. 9 and 10 are views illustrating a control output pad portions and a control output bump portions according to a comparative example;
FIG. 11 is a block diagram illustrating an electronic device according to an embodiment; and
FIG. 12 is a block diagram illustrating an electronic device according to another embodiment.

### DETAILED DESCRIPTION

Various example embodiments will be described more fully hereinafter with reference to the accompanying drawings, in which some example embodiments are shown. The present inventive concept may, however, be embodied in many different forms and should not be construed as limited to the example embodiments set forth herein. Rather, these example embodiments are provided so that this disclosure will be thorough and complete, and will fully convey the scope of the present inventive concept to those skilled in the art.

In the disclosure, various modifications can be made, various forms can be used, and specific embodiments will be illustrated in the drawings and described in detail in the text. However, this is not intended to limit the disclosure to a specific form disclosed, and it will be understood that all changes, equivalents, or substitutes which fall in the technical scope of the disclosure as defined by the appended claims should be included.

It will be understood that, although the terms first, second, third etc. may be used herein to describe various elements, these elements should not be limited by these terms. These terms are used to distinguish one element from another. Thus, a first element discussed below could be termed a second element without departing from the teachings of the present inventive concept. As used herein, the term "and/or" includes any and all combinations of one or more of the associated listed items.

It will be understood that when an element is referred to as being "connected" or "coupled" to another element, it can be directly connected or coupled to the other element or intervening element(s) may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular example embodiments only and is not intended to be limiting of the present inventive concept. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Hereinafter, embodiments will be described in detail with reference to the accompanying drawings. The same reference numerals are used for the same components in the drawings, and redundant descriptions of the same components will be omitted.

At least one embodiment is directed to a display device with an optimized driving chip configuration that enhances signal transmission reliability while reducing manufacturing costs. The display device includes a substrate with a display area and a surrounding non-display area, where driving components such as a scan driver, an emission driver, and a driving chip are located. The driving chip is responsible for generating data voltages for pixels and control signals for scan and emission drivers. These signals are transmitted through data output pads and control output pads arranged in a designated pad area of a non-display region.

In this embodiment, the number of control output pads varies based on the specific control signal being transmitted. Unlike conventional designs where control output pads are uniformly arranged, this embodiment adjusts the number of control output pads based on the requirements of different control signals. This non-uniform distribution optimizes signal integrity by accounting for variations in electrical potential differences between adjacent control signals. By strategically allocating more control output pads for signals with larger voltage variations and fewer for signals with smaller variations, this embodiment reduces the likelihood of open defects that could otherwise lead to signal transmission failures.

Furthermore, this optimized pad arrangement enables a more compact and cost-effective driving chip without compromising display performance. The embodiment also enhances manufacturing efficiency by reducing the complexity of the chip design, while increasing reliability by preventing signal loss due to misalignment or electrical interference. Thus, the embodiment provides a more reliable and cost-efficient solution for flat panel display technology, particularly for applications in OLED and LCD screens.

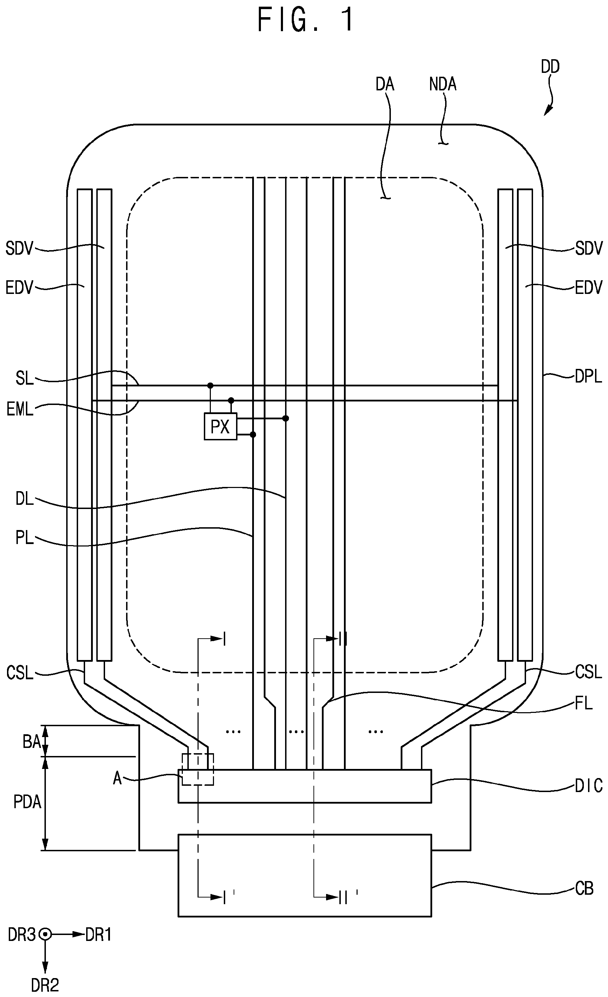

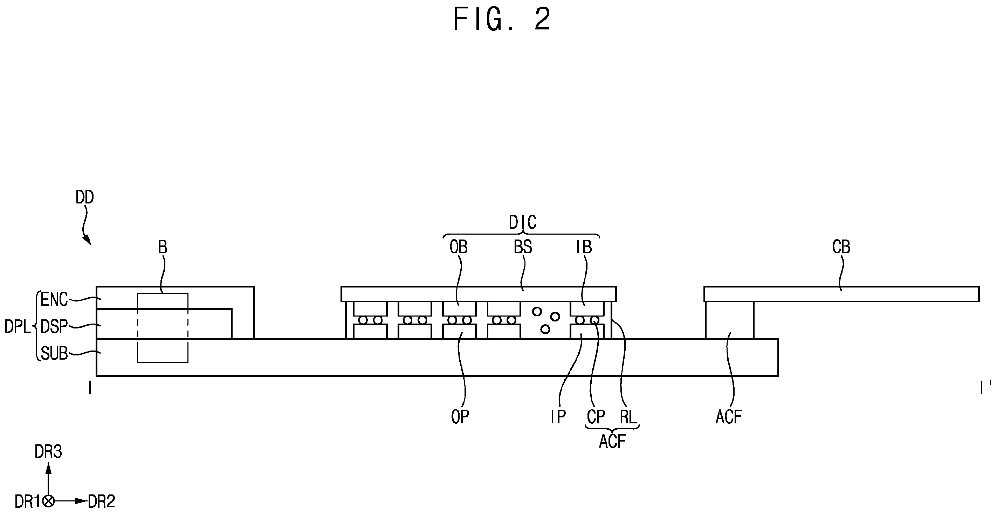

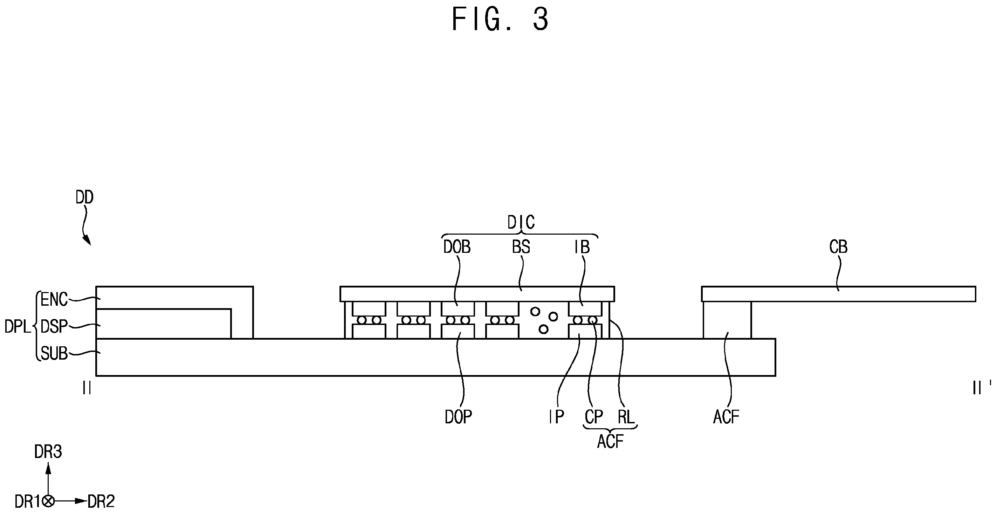

FIG. 1 is a plan view illustrating a display device according to an embodiment. FIG. 2 is a cross-sectional view taken along line I-I' of FIG. 1. FIG. 3 is a cross-sectional view taken along line II-II' of FIG. 1.

Referring to FIGS. 1 to 3, a display device DD according to an embodiment may include a display panel DPL, a scan driver SDV (e.g., a first driver circuit), an emission driver EDV (e.g., a second driver circuit), a driving chip DIC, a circuit board CB, and an anisotropic conductive film ACF.

A display panel DPL may include a substrate SUB, a display portion DSP, and an encapsulation layer ENC. The substrate SUB may include a display area DA and a non-display area NDA. The display portion DSP may be arranged in the display area DA on the substrate SUB. The encapsulation layer ENC may be arranged on the display portion DSP and may cover the display portion DSP.

The display area DA may display an image. A plurality of pixels PX for generating the image may be arranged in the display area DA. In an embodiment, the pixels PX may be arranged in a matrix form. For example, each of the pixels PX may emit one of red light, green light, and blue light, but embodiments are not limited thereto.

Each of the pixels PX may include a pixel circuit and a light emitting element. The pixel circuit may include at least one thin film transistor and at least one capacitor. The thin film transistor may generate a driving current and may provide the generated driving current to the light emitting element. The light emitting element may emit light based on the driving current. For example, the light emitting element may include an organic light emitting diode, an inorganic light emitting diode, a quantum dot light emitting diode, a micro light emitting diode, or the like. The light emitted from each of the pixels PX may be combined to generate the image.

The non-display area NDA may be located around the display area DA. For example, the non-display area NDA may surround at least a portion of the display area DA in a plan view. The non-display area NDA may not display an image.

In an embodiment, the non-display area NDA includes a bending area BA and a pad area PDA. The bending area BA is a portion of the non-display area where the substrate is designed to bend.

The bending area BA may extend in a first direction DR1. A portion of the substrate SUB overlapping the bending area BA may be bent with respect to a bending axis extending in the first direction DR1. The portion of the substrate SUB overlapping the bending area BA may be bent such that the driving chip DIC and the circuit board CB are located under the substrate SUB (e.g., in a direction opposite to a third direction DR3 from the substrate SUB).

As illustrated in FIG. 1, when the display panel DPL is in an unbent state, the bending area BA may be located between the display area DA and the pad area PDA in a plan view. Hereinafter, unless otherwise specified, the components of the display device DD will be described assuming the display panel DPL is in the unbent state.

In an embodiment, the pad area PDA may be located on one side of the display area DA. For example, the pad area PDA may be located in a second direction DR2 crossing the first direction DR1 from the display area DA. For example, the second direction DR2 may be perpendicular to the first direction DR1. The pad area PDA may have a shape extending along one side of the display device DD. For example, the pad area PDA may have a shape extending in the first direction DR1.

The scan driver SDV may be arranged in the non-display area NDA on the substrate SUB. The scan driver SDV may generate a scan signal provided to the pixels PX.

The emission driver EDV may be arranged in the non-display area NDA on the substrate SUB. The emission driver EDV may generate an emission signal that is provided to pixels PX.

In an embodiment, each of the scan driver SDV and the emission driver EDV may be integrated on the display panel DPL. FIG. 1 illustrates that two scan drivers SDV are respectively located on left and right sides of the display area DA and two emission drivers EDV are respectively located on left and right sides of the display area DA in a plan view, but this is merely an example and embodiments are not limited thereto. For example, the scan driver SDV and/or the emission driver EDV may be located only on one of the left and right sides of the display area DA, or may be located on top side or bottom side of the display area DA in a plan view.

The driving chip DIC may be located in the non-display area NDA on the substrate SUB. The driving chip DIC may be located in the pad area PDA on the substrate SUB. The driving chip DIC may overlap the pad area PDA in a plan view.

In an embodiment, the driving chip DIC may include a data driver (e.g., a driver circuit) and a signal controller (e.g., a controller circuit). The data driver may generate a data voltage that is provided to pixels PX. The signal controller may generate control signals that are provided to the scan driver SDV, the emission driver EDV, and the data driver. The control signals may include various signals (e.g., a scan start signal, a scan clock signal, an initialization control signal, an emission start signal, an emission clock signal, or the like) for controlling driving of the scan driver SDV, the emission driver EDV, and the data driver.

In an embodiment, the data driver and the signal controller may be mounted on the display panel DPL in the form of an integrated circuit chip. In an embodiment, the driving chip DIC may be mounted on the substrate SUB in a chip on plastic ("COP") manner or a chip on glass ("COG") manner, but embodiments are not limited thereto. In an embodiment, the data driver and the signal controller may be formed as a single chip.

The circuit board CB may be connected to one end of the display panel DPL. For example, the circuit board CB may include a printed circuit board ("PCB"), a flexible printed circuit board ("FPCB"), a flexible flat cable ("FFC"), or the like. A processor and/or a memory may be located on the circuit board CB.

The display device DD may further include a voltage generator that generates various voltages, such as a driving power voltage, a common power voltage, or the like, provided to the display panel DPL. The voltage generator may be included in the driving chip DIC or the circuit board CB.

The display panel DPL may include lines for transmitting various signals and/or voltages. In an embodiment, a data line DL, a scan line SL, an emission line EML, and a driving power voltage line PL connected to the pixels PX may be arranged in the display area DA. A control signal line CSL connected to the scan driver SDV or the emission driver EDV and a fan-out line FL connected to the data line DL may be arranged in the non-display area NDA.

The scan line SL may be electrically connected to the scan driver SDV. The scan line SL may be configured to receive the scan signal from the scan driver SDV and may provide the scan signal to the pixels PX. In an embodiment, the scan line SL may extend in the first direction DR1.

The emission line EML may be electrically connected to the emission driver EDV. The emission line EML may be configured to receive the emission signal from the emission driver EDV and may provide the emission signal to the pixels PX. For example, an active period of the emission signal may be an emission period of the display device DD, and an inactive period of the emission signal may be a non-emission period of the display device DD. In an embodiment, the emission line EML may extend in the first direction DR1.

The data line DL may be electrically connected to the driving chip DIC through the fan-out line FL. The data line DL may be electrically connected to the data driver through the fan-out line FL. The fan-out line FL may be configured to receive the data voltage from the data driver and may provide the data voltage to the data line DL. The data line DL may provide the data voltage to the pixels PX. In an embodiment, the data line DL may extend in the second direction DR2.

The driving power voltage line PL may be configured to receive the driving power voltage from the driving chip DIC or the circuit board CB and may provide the driving power voltage to the pixels PX. For example, the driving power voltage may be a high power voltage for driving the pixels PX. In an embodiment, the driving power voltage line PL may extend in the second direction DR2.

A common power voltage line may be arranged in the non-display area NDA. The common power voltage line may be configured to receive the common power voltage from the driving chip DIC or the circuit board CB and may provide the common power voltage to the pixels PX. For example, the common power voltage may be a low power voltage having a lower level than the high power voltage.

Control signal lines CSL may be electrically connected to the driving chip DIC. Each of the control signal lines CSL may be electrically connected to the scan driver SDV or the emission driver EDV. Each of the control signal lines CSL may be configured to receive one of the control signals from the driving chip DIC and may provide the control signal to the scan driver SDV or the emission driver EDV.

The display panel DPL may include pad portions arranged in the pad area PDA. The pad portions may be configured to receive various signals and/or voltages from the driving chip DIC and/or the circuit board CB.

Each of the pad portions may include a plurality of pads. Each of the pads may include a conductive material, such as a metal, an alloy, a conductive metal nitride, a conductive metal oxide, a transparent conductive material, or the like. For example, each of the pads may include gold (Au), silver (Ag), aluminum (Al), platinum (Pt), nickel (Ni), titanium (Ti), palladium (Pd), magnesium (Mg), calcium (Ca), lithium (Li), chromium (Cr), tantalum (Ta), tungsten (W), copper (Cu), molybdenum (Mo), scandium (Sc), neodymium (Nd), iridium (Ir), alloys containing aluminum, alloys containing silver, alloys containing copper, alloys containing molybdenum, aluminum nitride (AlNₓ), tungsten 4nitride (WNₓ), titanium nitride (TiNₓ), chromium nitride (CrNₓ), tantalum nitride (TaNₓ), strontium ruthenium oxide (SrRuOₓ), zinc oxide (ZnOₓ), indium tin oxide (ITO), tin oxide (SnOₓ), indium oxide (InOₓ), gallium oxide (GaOₓ), indium zinc oxide (IZO), or the like. These materials may be used alone or in combination with each other. Each of the pads may have a single-layered structure or a multi-layered structure including a plurality of conductive layers.

Hereinafter, the pad portions that overlap the driving chip DIC in a plan view and are electrically connected to the driving chip DIC are described in more detail.

As illustrated in FIGS. 2 and 3, in an embodiment, the display panel DPL may include an input pad portion including a plurality of input pads IP, a control output pad portion including a plurality of control output pads OP, and a data output pad portion including a plurality of data output pads DOP. Each of the input pad portion, the control output pad portion, and the data output pad portion may overlap the driving chip DIC in a plan view. In an embodiment, in a plan view, two control output pad portions may be respectively located on left and right sides of the data output pad portion, but this is merely an example and embodiments are not limited thereto.

The Input pads IP may be arranged in the pad area PDA. The input pads IP may transmit signals and/or voltages provided from the circuit board CB to the driving chip DIC.

The control output pads OP may be arranged in the pad area PDA. The control output pads OP may be configured to receive the control signals generated from the signal controller of the driving chip DIC. Each of the control output pads OP may be configured to receive one of the control signals. The control signal input to each of the control output pads OP may be provided to the scan driver SDV or the emission driver EDV through the control signal line CSL.

The data output pads DOP may be arranged in the pad area PDA. The data output pads DOP may be configured to receive the data voltages provided from the data driver of the driving chip DIC. Each of the data output pads DOP may be configured to receive one of the data voltages. The data voltage input to each data output pad DOP may be provided to the pixels PX through the fan-out line FL and the data line DL.

The driving chip DIC may include a base layer BS, the data driver, the signal controller, and bump portions.

In an embodiment, the base layer BS may include plastic, such as polyimide, but embodiments are not limited thereto. The bump portions may be arranged on one surface (e.g., a lower surface) of the base layer BS facing the substrate SUB. Each of the bump portions may include a plurality of bumps. Each of the bumps may include a conductive material.

In an embodiment, the driving chip DIC may include an input bump portion including a plurality of input bumps IB, a control output bump portion including a plurality of control output bumps OB, and a data output bump portion including a plurality of data output bumps DOB. The input bump portion may overlap the input pad portion, the control output bump portion may overlap the control output pad portion, and the data output bump portion may overlap the data output pad portion.

The input bumps IB may correspond one-to-one to the input pads IP. In a plan view, the input bumps IB may overlap the input pads IP, respectively. The input bumps IB may be electrically connected to the input pads IP, respectively. The input bumps IB may be configured to receive signals and/or voltages provided from the circuit board CB through the input pads IP.

The control output bumps OB may correspond one-to-one to the control output pads OP. In a plan view, the control output bumps OB may overlap the control output pads OP, respectively. The control output bumps OB may be electrically connected to the control output pads OP, respectively. The control output bumps OB may be electrically connected to the signal controller and may be configured to receive the control signals generated from the signal controller. Each of the control output bumps OB may be configured to receive any one of the control signals.

The data output bumps DOB may correspond one-to-one to the data output pads DOP. In a plan view, the data output bumps DOB may overlap the data output pads DOP, respectively. The data output bumps DOB may be electrically connected to the data output pads DOP, respectively. The data output bumps DOB may be electrically connected to the data driver and may be configured to receive the data voltages generated from the data driver. Each of the data output bumps DOB may be configured to receive one of the data voltages.

The anisotropic conductive film ACF may be arranged in the pad area PA between the substrate SUB and the driving chip DIC. The anisotropic conductive film ACF may be arranged between the input pads IP and the input bumps IB, between the control output pads OP and the control output bumps OB, and between the data output pads DOP and the data output bumps DOB.

The anisotropic conductive film ACF may bond the driving chip DIC to the display panel DPL. The anisotropic conductive film ACF may electrically connect the pad portions of the display panel DPL and the bump portions of the driving chip DIC to each other. The anisotropic conductive film ACF may electrically connect the input pads IP and the input bumps IB to each other, respectively. The anisotropic conductive film ACF may electrically connect the control output pads OP and the control output bumps OB to each other, respectively. The anisotropic conductive film ACF may electrically connect the data output pads DOP and the data output bumps DOB to each other, respectively.

In an embodiment, the anisotropic conductive film ACF includes a resin layer RL and a plurality of conductive particles CP. The conductive particles CP may be arranged in the resin layer RL. The resin layer RL may extend from the substrate SUB in the third direction DR3 towards the base layer BS.

The resin layer RL may include an insulating polymer material. For example, the resin layer RL may include an insulating polymer material, such as an epoxy resin, an acrylic resin, a phenol resin, a melamine resin, a diallylphthalate resin, a urea resin, a polyimide resin, a polystyrene resin, a polyurethane resin, a polyethylene resin, a polyvinyl acetate resin, or the like. These materials may be used alone or in combination with each other.

The conductive particles CP may be arranged between the pad portions and the bump portions. The conductive particles CP may be arranged between the input pads IP and the input bumps IB, between the control output pads OP and the control output bumps OB, and between the data output pads DOP and the data output bumps DOB. Accordingly, the conductive particles CP may electrically connect the pad portions of the display panel DPL and the bump portions of the driving chip DIC to each other. In an embodiment, each of the conductive particles CP may include a core including an insulating polymer material and a conductive layer surrounding the core and including a conductive metal material (e.g., Ni).

As illustrated in FIGS. 2 and 3, the anisotropic conductive film ACF may also be arranged between the substrate SUB and the circuit board CB. The anisotropic conductive film ACF may bond the circuit board CB to the display panel DPL.

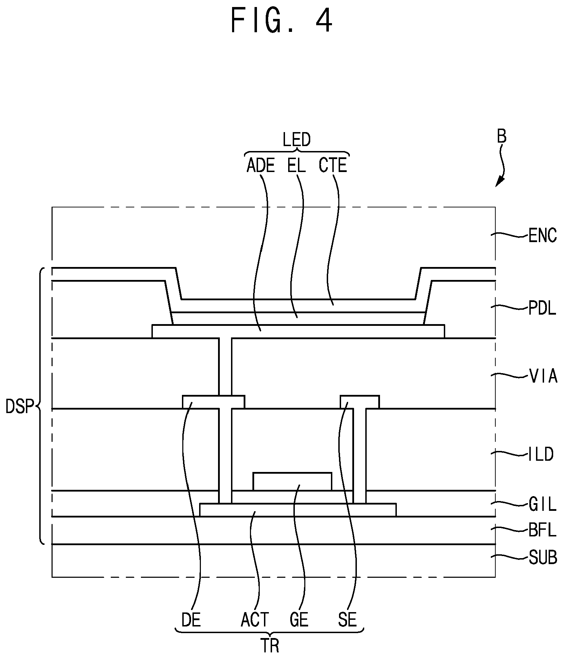

FIG. 4 is an enlarged plan view illustrating an example of area B of FIG. 2.

Hereinafter, the display area DA of the display panel DPL will be described in more detail with reference to FIG. 4.

Referring to FIGS. 1, 2, and 4, the display panel DPL may include the substrate SUB, the display portion DSP, and the encapsulation layer ENC. The display portion DSP may include a buffer layer BFL, a thin film transistor TR, a gate insulating layer GIL, an interlayer insulating layer ILD, a via insulating layer VIA, a light emitting element LED, and a pixel defining layer PDL. The thin film transistor TR may include an active layer ACT, a gate electrode GE, a first electrode SE, and a second electrode DE. The light emitting element LED may include an anode electrode ADE, an emission layer EL, and a cathode electrode CTE.

The substrate SUB may be an insulating substrate including or formed of a transparent material or a non-transparent material. In an embodiment, the substrate SUB may be a flexible substrate including a polymer resin. For example, the substrate SUB may have a structure in which a first polyimide layer, a barrier layer, and a second polyimide layer are stacked, but embodiments are not limited thereto. In an embodiment, the substrate SUB may be a rigid substrate including glass, quartz, or the like.

The buffer layer BFL may be arranged on the substrate SUB. The buffer layer BFL may prevent or reduce impurities, such as oxygen or moisture, from penetrating into an upper portion of the substrate SUB through the substrate SUB. The buffer layer BFL may include an inorganic material. In an embodiment, for example, the buffer layer BFL may include silicon oxide (SiOₓ), silicon nitride (SiNₓ), silicon oxynitride (SiOₓN_{y}), silicon oxycarbide (SiOₓC_{y}), silicon carbonitride (SiCₓN_{y}), aluminum oxide (AlOₓ), aluminum nitride (AlNₓ), tantalum oxide (TaOₓ), hafnium oxide (HfOₓ), zirconium oxide (ZrOₓ), titanium oxide (TiOₓ), or the like. These materials may be used alone or in combination with each other. The buffer layer BFL may have a single-layered structure or a multi-layered structure including a plurality of insulating layers.

The active layer ACT may be arranged on the buffer layer BFL. The active layer ACT may include an oxide semiconductor, a silicon semiconductor, an organic semiconductor, or the like. In an embodiment, for example, the oxide semiconductor may include at least one of oxides of indium (In), gallium (Ga), tin (Sn), zirconium (Zr), vanadium (V), hafnium (Hf), cadmium (Cd), germanium (Ge), chromium (Cr), titanium (Ti), and zinc (Zn). The silicon semiconductor may include an amorphous silicon, a polycrystalline silicon, or the like. The active layer ACT may include a source area, a drain area, and a channel area positioned between the source area and the drain area.

The gate insulating layer GIL may be arranged on the active layer ACT. The gate insulating layer GIL may cover the active layer ACT on the buffer layer BFL. The gate insulating layer GIL may include an inorganic insulating material. The gate insulating layer GIL may be arranged entirely on the buffer layer BFL or may be arranged only under the gate electrode GE.

The gate electrode GE may be arranged on the gate insulating layer GIL. The gate electrode GE may overlap the channel area of the active layer ACT. The gate electrode GE may include a conductive material. The gate electrode GE may have a single-layered structure or a multi-layered structure including a plurality of conductive layers.

An interlayer insulating layer ILD may be arranged on the gate electrode GE. The interlayer insulating layer ILD may cover the gate electrode GE on the gate insulating layer GIL. The interlayer insulating layer ILD may include an inorganic insulating material and/or an organic insulating material.

The first electrode SE and the second electrode DE may be arranged on the interlayer insulating layer ILD. The first electrode SE and the second electrode DE may be connected to the source area and the drain area of the active layer ACT, respectively. Each of the first electrode SE and the second electrode DE may include a conductive material.

The via insulating layer VIA may be arranged on the first electrode SE and the second electrode DE. The via insulating layer VIA may include an organic insulating material. In an embodiment, for example, the via insulating layer VIA may include photoresist, polyacryl-based resin, polyimide-based resin, polyamide-based resin, siloxane-based resin, acryl-based resin, epoxy-based resin, or the like. These materials may be used alone or in combination with each other.

The anode electrode ADE may be arranged on the via insulating layer VIA. The anode electrode ADE may include a conductive material. The anode electrode ADE may have a single-layered structure or a multi-layered structure including a plurality of conductive layers.

In one embodiment, the anode electrode ADE may be connected to the second electrode DE through a contact hole formed in a via insulating layer VIA. Accordingly, the anode electrode ADE may be electrically connected to the thin film transistor TR. In another embodiment, the anode electrode ADE may be electrically connected to the driving power voltage line PL of FIG. 1, and the cathode electrode CTE may be electrically connected to the second electrode DE.

The pixel defining layer PDL may be arranged on the anode electrode ADE. The pixel defining layer PDL may cover a peripheral portion of the anode electrode ADE, and may define a pixel opening exposing a central portion of the anode electrode ADE. The pixel defining layer PDL may include an organic insulating material.

The emission layer EL may be arranged on the anode electrode ADE. The emission layer EL may be arranged in the pixel opening of the pixel defining layer PDL to correspond to corresponding anode electrode ADE. In an embodiment, the emission layer EL may be arranged on the entire display area DA. For example, the emission layer EL may extend across the entire display area DA. In an embodiment, the emission layer EL may include at least one of an organic light emitting material or quantum dot, but embodiments are not limited thereto.

In an embodiment, the organic light emitting material may include a low molecular organic compound or a high molecular organic compound. Examples of the low molecular organic compound may include copper phthalocyanine, N,N'-diphenylbenzidine, tris-(8-hydroxyquinoline)aluminum, or the like. Examples of the high molecular organic compound may include poly(3,4-ethylenedioxythiophene), polyaniline, poly-phenylenevinylene, polyfluorene, or the like. These materials can be used alone or in a combination thereof.

In an embodiment, the quantum dot may include a core including a Group II-VI compound, a Group III-V compound, a Group IV-VI compound, a Group IV element, and/or a Group IV compound. In an embodiment, the quantum dot may have a core-shell structure including the core and a shell surrounding the core. The shell may serve as a protection layer for preventing the core from being chemically denatured to maintain semiconductor characteristics, and may serve as a charging layer for imparting electrophoretic characteristics to the quantum dot.

The cathode electrode CTE may be arranged on the emission layer EL. The cathode electrode CTE may also be arranged on the pixel defining layer PDL. The cathode electrode CTE may include a conductive material.

The anode electrode ADE, the emission layer EL, and the cathode electrode CTE may constitute the light emitting element LED. The light emitting element LED may further include various functional layers (e.g., a hole injection layer, a hole transport layer, an electron transport layer, an electron injection layer, or the like) arranged between the anode electrode ADE and the emission layer EL or between the emission layer EL and the cathode electrode CTE.

The encapsulation layer ENC may be arranged on the cathode electrode CTE. The encapsulation layer ENC may include at least one inorganic encapsulation layer and at least one organic encapsulation layer. In an embodiment, the encapsulation layer ENC may include a first inorganic encapsulation layer arranged on the cathode electrode CTE, an organic encapsulation layer arranged on the first inorganic encapsulation layer, and a second inorganic encapsulation layer arranged on the organic encapsulation layer. The encapsulation layer ENC may cover the light emitting elements LED in the entire display area DA. For example, the encapsulation layer ENC may be a single continuous layer that extends over multiple LEDs. The encapsulation layer ENC may prevent or reduce impurities, moisture, or the like from penetrating into the light emitting elements LED from the outside.

The display device DD may further include various functional layers (e.g., a touch sensing layer, a color filter layer, a light collecting layer, or the like) arranged on the encapsulation layer ENC.

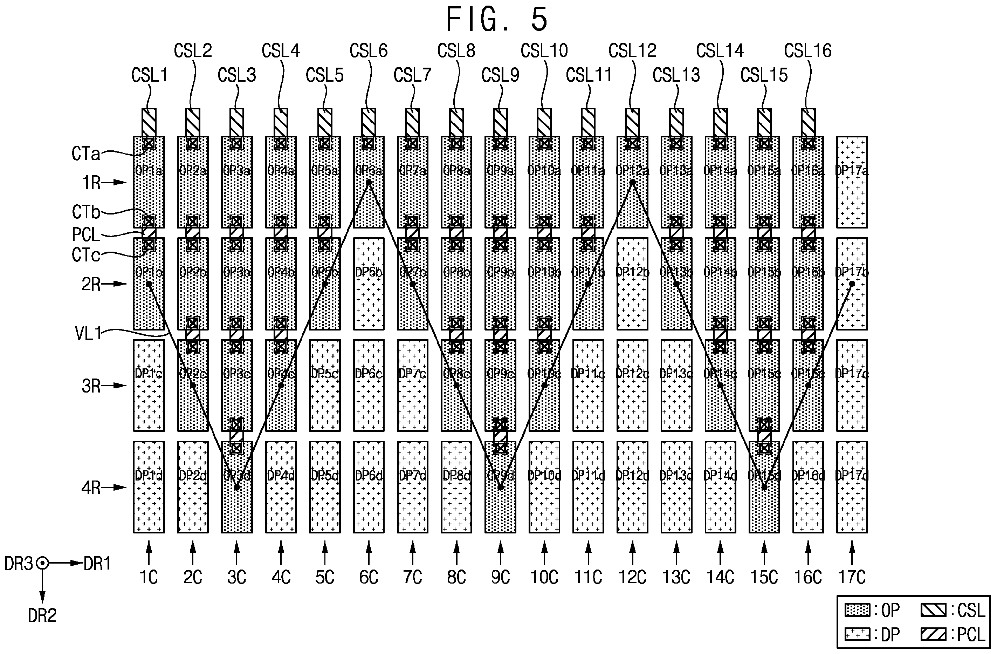

FIGS. 5 to 7 are enlarged plan views illustrating an example of area A of FIG. 1.

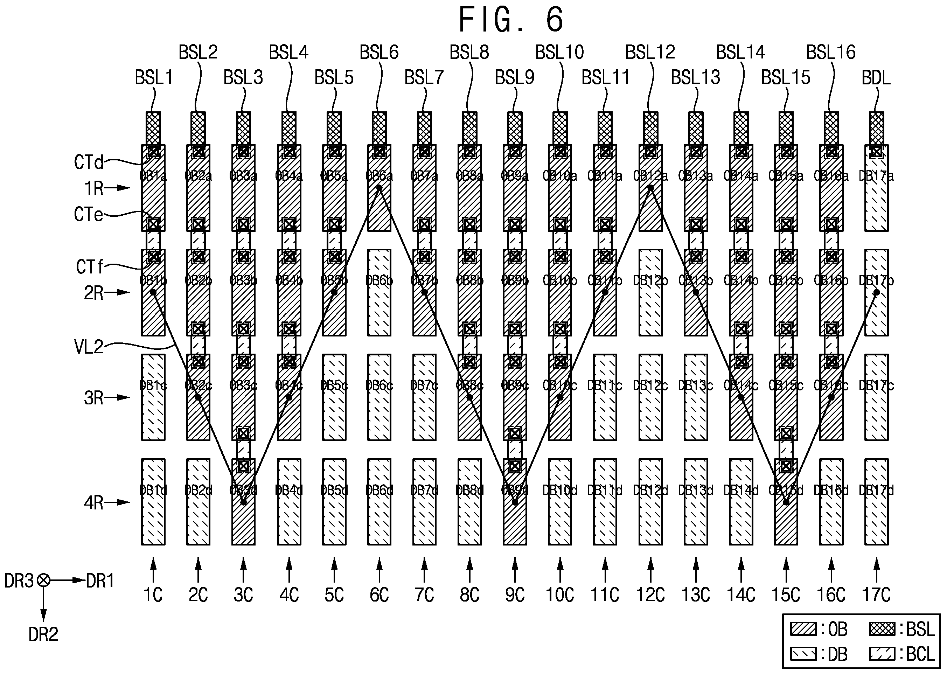

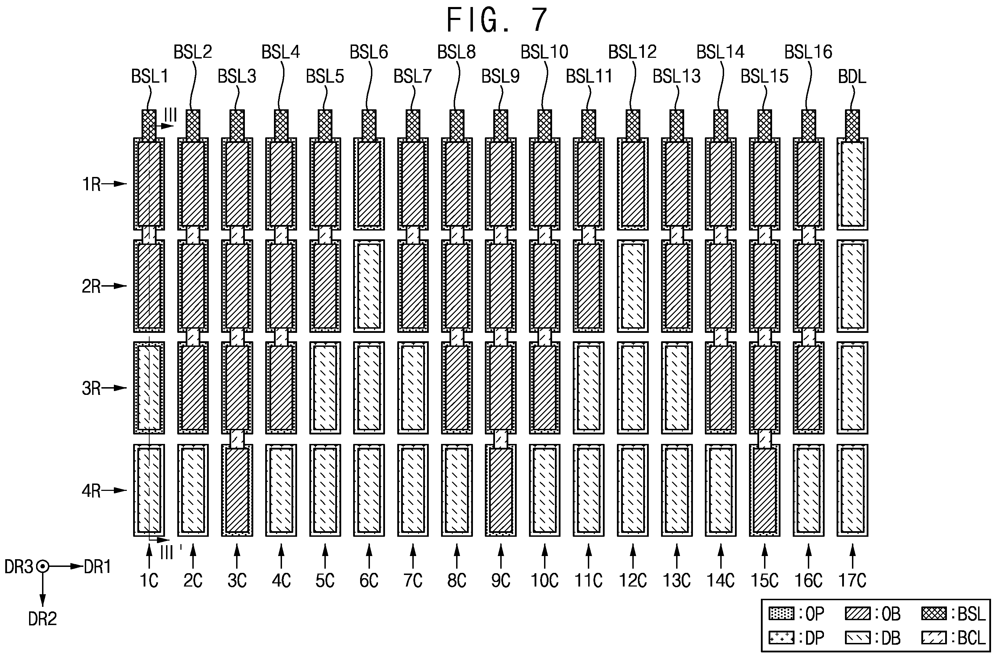

In FIGS. 5 to 7, some configurations of the display device DD are selectively illustrated for convenience. FIG. 5 is a top view schematically illustrating the control output pad portion including the control output pads OP of the display panel DPL. FIG. 6 is a bottom view schematically illustrating the control output bump portion including the control output bumps OB of the driving chip DIC. FIG. 7 is a plan view illustrating the control output pad portion of FIG. 5 and the control output bump portion of FIG. 6 together.

Hereinafter, the control output pad portion of the display panel DPL and the control output bump portion of the driving chip DIC will be described in more detail with reference to FIGS. 5 to 7.

Referring to FIGS. 1, 5, and 7, the display panel DPL may include the control output pad portion including the plurality of control output pads OP and a plurality of dummy pads DP adjacent to the control output pads OP. The control output pads OP and the dummy pads DP may be arranged in the pad area PDA. In an embodiment, each of the dummy pads DP is electrically floated. For example, the dummy pads DP are not electrically connected to any circuit, voltage, or signal line.

In an embodiment, pads including the control output pads OP and the dummy pads DP are arranged in a plurality of rows and a plurality of columns. Here, a row direction may be the first direction DR1, and a column direction may be the second direction DR2. That is, the pads arranged in each row may be arranged along the first direction DR1, and the pads arranged in each column may be arranged along the second direction DR2.

For example, as illustrated in FIG. 5, the pads may be arranged in four rows 1R to 4R. A first row 1R may be the row closest to the display area DA among the plurality of rows. However, this is merely an example and embodiments are not limited thereto. For example, the pads may be arranged in two, three, or five or more rows. In addition, FIG. 5 only illustrates seventeen columns 1C to 17C and the control output pads OP and the dummy pads DP arranged therein, but other pads, for example, the data output pads DOP of FIG. 3, may be arranged in other columns.

In an embodiment, the number of columns, in which at least one control output pad OP are arranged, among the plurality of columns is determined depending on the number of the control signals. For example, when the signal controller generates sixteen control signals, the control output pads OP may be arranged in sixteen columns 1C to 16C as illustrated in FIG. 5. Hereinafter, first to sixteenth columns 1C to 16C, in which at least one control output pad OP are arranged, among the plurality of columns may be referred to as control pad columns, and seventeenth column 17C, in which only the dummy pads DP are arranged, among the plurality of columns may be referred to as a dummy pad column. The number of the control pad columns may be variously changed depending on the number of the control signals.

In an embodiment, in each of the control pad columns, a sum of the number of the control output pads OP and the number of the dummy pads DP is constant. For example, as illustrated in FIG. 5, in each of the first to sixteenth columns 1C to 16C, the sum of the number of the control output pads OP and the number of the dummy pads DP is four. However, this is merely an example and embodiments are not limited thereto.

At least one control output pad OP may be arranged in each of the control pad columns. In an embodiment, the number of the control output pads OP arranged in some of the control pad columns is different from the number of the control output pads OP arranged in other of the control pad columns. In an embodiment, the number of the dummy pads DP arranged in some of the control pad columns is different from the number of the dummy pads DP arranged in other of the control pad columns.

For example, as illustrated in FIG. 5, in each of the sixth column 6C and the twelfth column 12C, one control output pad OP and three dummy pads DP are arranged. In each of the first column 1C, the fifth column 5C, the seventh column 7C, the eleventh column 11C, and the thirteenth column 13C, two control output pads OP and two dummy pads DP are arranged. In each of the second column 2C, the fourth column 4C, the eighth column 8C, the tenth column 10C, the fourteenth column 14C, and the sixteenth column 16C, three control output pads OP and one dummy pad DP are arranged. In each of the third column 3C, the ninth column 9C, and the fifteenth column 15C, four control output pads OP are arranged and the dummy pad DP is not arranged or is omitted.

In an embodiment, the number of the control output pads OP arranged in some of the plurality of rows is different from the number of the control output pads OP arranged in other of the plurality of rows. In an embodiment, the number of the dummy pads DP arranged in some of the control pad rows is different from the number of the dummy pads DP arranged in other of the control pad rows.

In an embodiment, as illustrated in FIG. 5, as the row is closer to the display area DA, the number of the control output pads OP arranged in the row becomes greater and the number of the dummy pads DP arranged in the row becomes less. That is, as the row is farther from the display area DA, the number of the control output pads OP arranged in the row may become less and the number of the dummy pads DP arranged in the row may become greater.

In an embodiment, the number of the control output pads OP arranged in the first row 1R is different from the number of the control output pads OP arranged in an n-th (n is a natural number greater than or equal to 2) row among the plurality of rows. The number of the control output pads OP arranged in the first row 1R may be greater than the number of the control output pads OP arranged in the n-th row. As described above, the first row 1R may be the row closest to the display area DA among the plurality of rows.

In an embodiment, the number of the dummy pads DP arranged in the first row 1R is different from the number of the dummy pads DP arranged in n-th row. The number of the dummy pads DP arranged in the first row 1R may be less than the number of the dummy pads DP arranged in the n-th row.

For example, as illustrated in FIG. 5, in the control pad columns (e.g., the first to sixteenth columns 1C to 16C), in the first row 1R, sixteen control output pads OP are arranged and no dummy pads DP are arranged. In the second row 2R, fourteen control output pads OP and two dummy pads DP are arranged. In the third row 3R, nine control output pads OP and seven dummy pads DP are arranged. In the fourth row 4R, three control output pads OP and thirteen dummy pads DP are arranged.

In an embodiment, in each of the control pad columns, the dummy pads DP are located further away from the display area DA than the control output pads OP. That is, in each of some columns, in which at least one dummy pad DP are arranged, among the control pad columns, the dummy pad DP may be spaced apart from the display area DA with the control output pad OP interposed therebetween.

In an embodiment, in all of the control pad columns, the control output pads OP may be arranged in the first row 1R. As illustrated in FIG. 5, the control output pads OP1a to OP16a arranged in the first row 1R may be connected to corresponding ones of the control signal lines CSL, respectively.

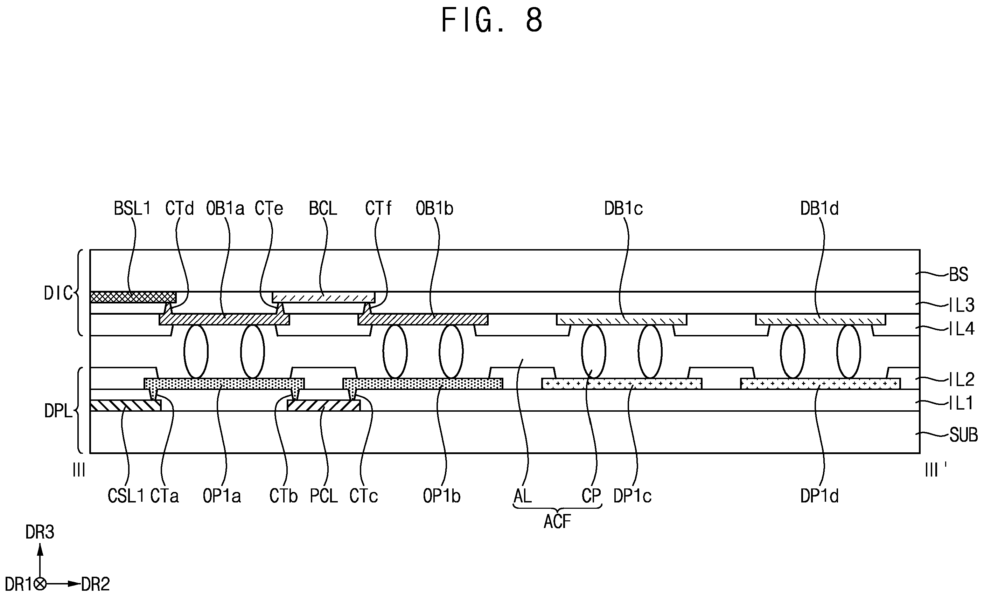

In an embodiment, as described below with reference to FIG. 8, the control signal lines CSL may be arranged on a different layer from the control output pads OP. For example, each of the control signal lines CSL may partially overlap one control output pad OP arranged in the first row 1R among the control output pads OP arranged in the corresponding column in a plan view, and may be electrically connected to the one control output pad OP through a contact hole.

For example, as illustrated in FIGS. 5, 7, and 8, a first control signal line CSL1 may partially overlap the control output pad OP1a arranged in the first row 1R and the first column 1C in a plan view, and may be electrically connected to the control output pad OP1a through a contact hole CTa. The above described description may be similarly applied to other control output pads OP2a to OP16a arranged in the first row 1R and the second to sixteenth control signal lines CSL2 to CSL16.

In an embodiment, as illustrated in FIG. 5, a virtual line VL1 connecting centers of outermost control output pads OP1b, OP2c, OP3d, OP4c, OP5b, OP6a, OP7b, OP8c, OP9d, OP10c, OP11b, OP12a, OP13b, OP14c, OP15d, and OP16c may have a zigzag shape in a plan view. Each of the outer most control output pads OP1b, OP2c, OP3d, OP4c, OP5b, OP6a, OP7b, OP8c, OP9d, OP10c, OP11b, OP12a, OP13b, OP14c, OP15d, and OP16c may be one pad, which is furthest from the display area DA, of the control output pads OP arranged in each of the control pad columns. However, this is merely an example, embodiments are not limited thereto, and the arrangement of the control output pads OP and the dummy pads DP may be variously changed.

The control output pads OP may be arranged in a pattern that forms multiple triangular configurations across a plurality of rows. In one embodiment, a first row 1R includes 16 control output pads OP arranged in a continuous manner, spanning across the width of the pad area. In a second row 2R, three distinct sets of five control output pads OP are arranged, with each set spaced apart by a single intervening dummy pad DP, thereby introducing a separation between adjacent clusters of control output pads. In a third row 3R, three sets of three control output pads OP are positioned, with each set spaced apart from the others by three intervening dummy pads DP, further refining the triangular spacing. In a fourth row 4R, three sets of single control output pads OP are disposed, each set spaced apart from the others by two sets of five intervening dummy pads DP, forming a structured separation pattern.

This triangular arrangement of the control output pads OP may optimize signal integrity and spacing between control signals while mitigating potential electrical interference between adjacent pads. By incorporating dummy pads DP in a structured manner, the configuration ensures proper electrical isolation while maintaining a compact and efficient pad layout. The triangular configuration may further enhance alignment precision during fabrication and increase signal distribution uniformity across the display panel DPL.

In an embodiment, the control output pads OP arranged in each of the control pad columns are electrically connected to each other through a corresponding pad connection line PCL. For example, two control output pads OP1a and OP1b arranged in the first column 1C may be electrically connected to each other through a pad connection line PCL arranged between the control output pad OP1a and the control output pad OP1b. Three control output pads OP2a, OP2b, and OP2c arranged in the second column 2C may be electrically connected to each other through pad connection lines PCL respectively arranged between the control output pad OP2a and the control output pad OP2b and between the control output pad OP2b and the control output pad OP2c. Four control output pads OP3a, OP3b, OP3c, and OP3d arranged in the third column 3C may be electrically connected to each other through pad connection lines PCL respectively arranged between the control output pad OP3a and the control output pad OP3b, between the control output pad OP3b and the control output pad OP3c, and between the control output pad OP3c and the control output pad OP3d. The above described description may be similarly applied to other control output pads OP arranged in each of the fourth to sixteenth columns 4C to 16C.

In an embodiment, as described below with reference to FIG. 8, the pad connection lines PCL may be arranged on a different layer from the control output pads OP. For example, each of the pad connection lines PCL may partially overlap corresponding ones of the control output pads OP in a plan view, and may be electrically connected to the corresponding ones of the control output pads OP through a contact hole.

For example, as illustrated in FIGS. 5, 7, and 8, the pad connection line PCL arranged between the control output pad OP1a and the control output pad OP1b arranged in the first column 1C may partially overlap each of the control output pads OP1a and OP1b in a plan view, and may be electrically connected to the control output pads OP1a and OP1b through contact holes CTb and CTc, respectively. The above described description may be similarly applied to other control output pads OP and the pad connection lines PCL arranged in the second to sixteenth columns 2C to 16C.

In an embodiment, the control pad columns may be configured to receive different control signals from each other. In this specification, the control pad column configured to receive the control signal may mean that the control output pads OP arranged in the control pad column are configured to receive the control signal. For example, each of the control output pads OP1a and OP1b arranged in the first column 1C may be configured to receive a first control signal. Each of the control output pads OP2a, OP2b, and OP2c arranged in the second column 2C may be configured to receive a second control signal. Each of the control output pads OP3a, OP3b, OP3c, and OP3d arranged in the third column 3C may be configured to receive a third control signal. Similarly, the fourth to sixteenth columns C4 to C16 may be configured to receive fourth to sixteenth control signals, respectively.

In an embodiment, the number of the control output pads OP configured to receive one of the control signals may be different from the number of the control output pads OP configured to receive another of the control signals. For example, the number of the control output pads OP1a and OP1b configured to receive the first control signal (i.e., arranged in the first column 1C) may be two, the number of the control output pads OP2a, OP2b, and OP2c configured to receive the second control signal (i.e., arranged in the second column 2C) may be three, and the number of the control output pads OP3a, OP3b, OP3c, and OP3d configured to receive the third control signal (i.e., arranged in the third column 3C) may be four. That is, the number of the control output pads OP configured to receive the first control signal may be different from the number of the control output pads OP configured to receive the second control signal.

The number of the control output pads OP configured to receive each of the control signals may be determined depending on an electric potential difference between the control signals input to two of the adjacent control pad columns. In this specification, the electric potential difference between the control signals may be calculated using root mean square ("RMS") or average of an electric potential of each of the control signals.

A k-th (k is a natural number greater than or equal to 2) column among the control pad columns may be configured to receive a k-th control signal. As described above, this may mean that the control output pads OP arranged in the k-th column are configured to receive the k-th control signal. A (k-1)-th column adjacent to the k-th column in a direction opposite to the first direction DR1 may be configured to receive a (k-1)-th control signal. A (k+1)-th column adjacent to the k-th column in first direction DR1 may be configured to receive a (k+1)-th control signal.

In an embodiment, as the electric potential difference between the k-th control signal and the control signals input to two columns adjacent to the k-th column (e.g., the (k-1)-th control signal and the (k+1)-th control signal) is greater, the number of the control output pads OP configured to receive the k-th control signal (i.e., arranged in the k-th column) may be relatively greater. For example, as a sum of the electric potential difference between the (k-1)-th control signal and the k-th control signal and the electric potential difference between the k-th control signal and the (k+1)-th control signal is greater, the number of the control output pads OP configured to receive the k-th control signal (i.e., arranged in the k-th column) may be relatively greater.

For comparison, a p-th (p is a natural number greater than or equal to 3 and is different from k) column, in which a less number of the control output pads OP are arranged than the k-th column, among the control pad columns may be defined. That is, the number of the control output pads OP arranged in the k-th column may be greater than the number of the control output pads OP arranged in the p-th column. The number of the dummy pads DP arranged in the k-th column may be less than the number of the dummy pads DP arranged in the p-th column. A sum of the number of the control output pads OP and the number of the dummy pads DP arranged in the k-th column may be equal to a sum of the number of the control output pads OP and the number of the dummy pads DP arranged in the p-th column.

The p-th column may be configured to receive a p-th control signal. A (p-1)-th column adjacent to the p-th column in the direction opposite to the first direction DR1 may be configured to receive a (p-1)-th control signal. A (p+1)-th column adjacent to the p-th column in first direction DR1 may be configured to receive a (p+1)-th control signal.

The sum of the electric potential difference between the (k-1)-th control signal and the k-th control signal and the electric potential difference between the k-th control signal and the (k+1)-th control signal may be greater than a sum of the electric potential difference between the (p-1)-th control signal and the p-th control signal and the electric potential difference between the p-th control signal and the (p+1)-th control signal.

Specifically, an example where k is 3 and p is 6 will be described with reference to FIG. 5. Four control output pads OP3a, OP3b, OP3c, and OP3d may be arranged in the third column 3C, and one control output pad OP6a, which is less than this, may be arranged in the sixth column 6C. In this case, the electric potential difference between the third control signal input to the third column 3C and the control signals respectively input to the second and fourth columns 2C and 4C (the second control signal and the fourth control signal) may be relatively greater. In addition, the electric potential difference between the sixth control signal input to the sixth column 6C and the control signals respectively input to the fifth and seventh columns 5C and 7C (the fifth control signal and the seventh control signal) may be relatively less. For example, a sum of the electric potential difference between the third control signal and the second control signal and the electric potential difference between the third control signal and the fourth control signal may be greater than a sum of the electric potential difference between the sixth control signal and the fifth control signal and the electric potential difference between the sixth control signal and the seventh control signal

As the potential difference between the control signals respectively input to the control output pads OP arranged in the adjacent columns is greater, a probability of occurrence of an open defect, in which the conductive film of the conductive particle CP between the control output pad OP and the corresponding control output bump OB is lost and thereby the control output pad OP and the control output bump OB are electrically opened, may increase (see FIG. 2). For example, the third control signal may be greater than each of the second control signal and the fourth control signal, and the sum of the electric potential difference between the second control signal and the third control signal and the electric potential difference between the third control signal and the fourth control signal may be relatively greater. In this case, as illustrated in FIG. 5, on both sides of the control output pads OP3a, OP3b, and OP3c arranged in the first to third rows 1R, 2R, and 3R among the control output pads OP3a, OP3b, OP3c, and OP3d configured to receive the third control signal, the control output pads OP2a, OP2b, OP2c configured to receive the second control signal and the control output pads OP4a, OP4b, OP4c configured to receive the fourth control signal may be respectively arranged. Accordingly, the probability of occurrence of the open defect between the control output pads OP3a, OP3b, and OP3c arranged in the first to third rows 1R, 2R, and 3R and the corresponding control output bumps OB3a, OB3b, and OB3c may be relatively greater. However, according to embodiments, on both sides of the control output pad OP3d arranged in the fourth row 4R among the control output pads OP3a, OP3b, OP3c, and OP3d configured to receive the third control signal, dummy pads DP electrically floated may be arranged, instead of the control output pads OP. Accordingly, the probability of occurrence of the open defect between the control output pad OP3d arranged in the fourth row 4R and the corresponding control output bump OB3d may be relatively less. Therefore, the third control signal may be input to the control output pad OP3d through the control output bump OB3d. In addition, because the control output pads OP3a, OP3b, OP3c, and OP3d arranged in the third column 3C are electrically connected to each other through the corresponding pad connection lines PCL, the third control signal may be transmitted to the third control signal line CSL3. That is, according to the embodiments, even without adding a separate dummy pad column between the adjacent control pad columns, a problem of the control signals not being transmitted to the control signal lines CSL may be prevented or reduced. Therefore, a reliability of the display device DD may be improved without increasing a size of the driving chip DIC, and thus a manufacturing cost of the driving chip DIC and the display device DD may be reduced.

Referring to FIGS. 1, 6, and 7, the driving chip DIC may include the control output bump portion including the control output bumps OB and dummy bumps DB adjacent to the control output bumps OB. The control output bumps OB and the dummy bumps DB may overlap the pad area PDA. Each of the dummy bumps DB may be electrically floated.

As illustrated in FIG. 7, the control output bumps OB of the driving chip DIC may correspond one-to-one to the control output pads OP of the display panel DPL. The dummy bumps DB of the driving chip DIC may correspond one-to-one to the dummy pads DP of the display panel DPL. That is, the arrangement of the control output bumps OB and the dummy bumps DB may be substantially the same as or similar to the arrangement of the control output pads OP and the dummy pads DP described above. Therefore, repeated description will be omitted or simplified.

In an embodiment, the bumps including the control output bumps OB and the dummy bumps DB may be arranged in a plurality of rows and a plurality of columns.

In an embodiment, the number of columns, in which at least one of the control output bumps OB are arranged, among the plurality of columns may be determined depending on the number of the control signals. For example, the control output bumps OB may be arranged in the first to sixteenth columns 1C to 16C that are the control pad columns.

In an embodiment, in each of the control pad columns, a sum of the number of the control output bumps OB and the number of the dummy bumps DB may be constant.

At least one control output bump OB may be arranged in each of the control pad columns. In an embodiment, the number of the control output bumps OB arranged in some of the control pad columns may be different from the number of the control output bumps OB arranged in other of the control pad columns. In an embodiment, the number of the dummy bumps DB arranged in some of the control pad columns may be different from the number of the dummy bumps DB arranged in other of the control pad columns.

In an embodiment, the number of the control output bumps OB arranged in some of the plurality of rows may be different from the number of the control output bumps OB arranged in other of the plurality of rows. In an embodiment, the number of the dummy bumps DB arranged in some of the control pad rows may be different from the number of the dummy bumps DB arranged in other of the control pad rows.

In an embodiment, as illustrated in FIG. 6, as the row is closer to the display area DA (e.g., closer to a side surface of the driving chip DIC facing the display area DA), the number of the control output bumps OB arranged in the row may be greater and the number of the dummy bumps DB arranged in the row may be less. That is, as the row is farther from the display area DA, the number of the control output bumps OB arranged in the row may be less and the number of the dummy bumps DB arranged in the row may be greater.

In an embodiment, in each of the control pad columns, the dummy bumps DB may be located further away from the display area DA than the control output bumps OB. That is, in each of some columns, in which at least one dummy bump DB are arranged, among the control pad columns, the dummy bump DB may be spaced apart from the display area DA with the control output bump OB interposed therebetween.

In an embodiment, in all of the control pad columns, the control output bumps OB may be arranged in the first row 1R.

In an embodiment, as illustrated in FIG. 6, a virtual line VL2 connecting centers of outermost control output bumps OB1b, OB2c, OB3d, OB4c, OB5b, OB6a, OB7b, OB8c, OB9d, OB10c, OB11b, OB12a, OB13b, OB14c, OB15d, and OB16c may have a zigzag shape in a plan view. Each of the outer most control output pads OB1b, OB2c, OB3d, OB4c, OB5b, OB6a, OB7b, OB8c, OB9d, OB10c, OB11b, OB12a, OB13b, OB14c, OB15d, and OB16c may be one, which is furthest from the display area DA, of the control output bumps OB arranged in each of the control pad columns.

In an embodiment, the control output bumps OB arranged in each of the control pad columns may be electrically connected to each other through corresponding bump connection line BCL.

In an embodiment, as described below with reference to FIG. 8, the bump connection lines BCL may be arranged on a different layer from the control output bump OB. For example, each of the bump connection lines BCL may partially overlap corresponding ones of the control output bumps OB in a plan view, and may be electrically connected to the corresponding ones of the control output bumps OB through a contact hole.

For example, as illustrated in FIGS. 6, 7, and 8, the bump connection line BCL arranged between the control output bump OB1a and the control output bump OB1b arranged in the first column 1C may partially overlap each of the control output bumps OB1a and OB1b in a plan view, and may be electrically connected to the control output bumps OB1a and OB1b through contact holes CTe and CTf, respectively. The above described description may be similarly applied to other control output bumps OB and the bump connection lines BCL arranged in the second to sixteenth columns 2C to 16C.

The control output bumps OB arranged in each of the control pad columns may be electrically connected to corresponding one of bump control signal lines BSL. The bump control signal lines BSL may be electrically connected to the signal controller. The bump control signal lines BSL may respectively receive different control signals from the signal controller, and may respectively transmit the received control signals to corresponding ones of the control output bumps OB. For example, the first to sixteenth bump control signal lines BSL1 to BSL16 may respectively receive the first to sixteenth control signals from the signal controller.

In an embodiment, as described below with reference to FIG. 8, the bump control signal lines BSL may be arranged on a different layer from the control output bumps OB and the dummy bumps DB.

For example, as illustrated in FIG. 6, each of the bump control signal lines BSL may partially overlap one control output bump OB arranged in the first row 1R among the control output bumps OB arranged in the corresponding column in a plan view, and may be electrically connected to the one control output bump OB through a contact hole.

For example, as illustrated in FIGS. 6, 7, and 8, a first bump control signal line BSL1 may partially overlap the control output bump OB1a arranged in the first row 1R and the first column 1C in a plan view, and may be electrically connected to the control output bump OB1a through a contact hole CTd. The above described description may be similarly applied to other control output bumps OB2a to OB16a arranged in the first row 1R and the second to sixteenth bump control signal lines BSL2 to BSL16.

In an embodiment, unlike what is illustrated in the drawings, each of the bump control signal lines BSL may partially overlap one control output bump OB, which is furthest from the display area DA, among the control output bumps OB arranged in the corresponding column in a plan view, and may be electrically connected to the one control output bump OB through a contact hole. In this case, each of the bump control signal lines BSL may overlap at least one dummy bump DB in a plan view. For example, the first bump control signal line BSL1 may be electrically connected to the control output bump OB1b arranged in the second row 2R and the first column 1C through a contact hole, and may overlap the dummy bumps DB1c and DB1d arranged in the first column 1C in a plan view. Because the bump control signal lines BSL are arranged on a different layer from the dummy bumps DB, even when the bump control signal line BSL overlaps the dummy bump DB in a plan view, the bump control signal line BSL may not be electrically connected to the dummy bump DB.

In an embodiment, the number of the control output bumps OB configured to receive one of the control signals is different from the number of the control output bumps OB configured to receive another of the control signals.

The number of the control output bumps OB configured to receive each of the control signals may be determined depending on the electric potential difference between the control signals input to two of the adjacent control pad columns.

In an embodiment, some of the dummy bumps DB and some of the dummy pads DP are not electrically floated. For example, some of the dummy bumps DB and some of the dummy pads DP may be configured to receive a dummy voltage.

For example, as illustrated in FIG. 6, the dummy bump DB17a arranged in the first row 1R and the seventeenth column 17C may be electrically connected to a bump dummy line BDL, and may be configured to receive the dummy voltage through the bump dummy line BDL. For example, the dummy voltage may be the low power voltage. The dummy bump DB17a may be electrically connected to the dummy pad DP17a arranged in the first row 1R and the seventeenth column 17C of FIG. 5. Accordingly, the dummy pad DP17a may receive the dummy voltage. The dummy pad DP17a is not electrically connected to the control signal line CSL.

FIG. 8 is a cross-sectional view taken along line III-III' of FIG. 7.

Hereinafter, the cross-sectional structures of the control output pad portion of the display panel DPL and the control output bump portion of the driving chip DIC will be described in more detail with reference to FIGS. 5 to 8.

Referring to FIGS. 5 to 8, in an embodiment, the first control signal line CSL1 may be arranged on a different layer from the control output pads OP1a and OP1b and the dummy pads DP1c and DP1d. The pad connection line PCL may be arranged on a different layer from the control output pads OP1a and OP1b and the dummy pads DP1c and DP1d.

In an embodiment, the first control signal line CSL1 may be arranged on the same layer as the pad connection line PCL. For example, the first control signal line CSL1 and the pad connection line PCL may be arranged on one surface (e.g., an upper surface) of the substrate SUB. However, embodiments are not limited thereto.

A first insulating layer IL1 may be arranged on the first control signal line CSL1 and the pad connection line PCL. The first insulating layer IL1 may cover the first control signal line CSL1 and the pad connection line PCL on the one surface of the substrate SUB.

In an embodiment, the control output pads OP1a and OP1b may be arranged on the same layer as the dummy pads DP1c and DP1d. For example, the control output pads OP1a and OP1b and the dummy pads DP1c and DP1d may be arranged on the first insulating layer IL1. However, embodiments are not limited thereto.

The first control signal line CSL1 may partially overlap the control output pad OP1a in a plan view. For example, in a plan view, a first end of the first control signal line CSL1 may overlap a first end of the control output pad OP1a. A second end of the first control signal line CSL1 may be connected to the scan driver SDV or the emission driver EDV of FIG. 1.

The first insulating layer IL1 may define a contact hole CTa exposing the first end of the first control signal line CSL1. For example, a portion of the first insulating layer IL1 may be removed to form the contact hole CTa. The first end of the control output pad OP1a may contact the first end of the first control signal line CSL1 through the contact hole CTa. Accordingly, the control output pad OP1a may be electrically connected to the first control signal line CSL1.

The pad connection line PCL may partially overlap each of the control output pads OP1a and OP1b in a plan view. For example, in a plan view, a first end of the pad connection line PCL may overlap a second end of the control output pad OP1a, and a second end of the pad connection line PCL may overlap a first end of the control output pad OP1b.

The first insulating layer IL1 may define a contact hole CTb exposing the first end of the pad connection line PCL and a contact hole CTc exposing the second end of the pad connection line PCL. For example, respective portions of the first insulating layer IL1 may be removed to form the contact holes CTb and CTc. The second end of the control output pad OP1a may contact the first end of the pad connection line PCL through the contact hole CTb. The first end of the control output pad OP1b may contact the second end of the pad connection line PCL through the contact hole CTc. Accordingly, the control output pads OP1a and OP1b may be electrically connected to each other through the pad connection line PCL.

Each of the dummy pads DP1c and DP1d is not electrically connected to the control output pads OP1a and OP1b.

A second insulating layer IL2 may be arranged on the control output pads OP1a and OP1b and the dummy pads DP1c and DP1d. The second insulating layer IL2 may define openings each exposing a central portion of each of the control output pads OP1a and OP1b and the dummy pads DP1c and DP1d. For example, each of the first insulating layer IL1 and the second insulating layer IL2 may be any one of the insulating layers described with reference to FIG. 4.

The first bump control signal line BSL1 may be arranged on a different layer from the control output bumps OB1a and OB1b and the dummy bumps DB1c and DB1d. The bump connection line BCL may be arranged on a different layer from the control output bumps OB1a and OB1b and the dummy bumps DB1c and DB1d.

In an embodiment, the first bump control signal line BSL1 may be arranged on the same layer as the bump connection line BCL. For example, the first bump control signal line BSL1 and the bump connection line BCL may be arranged on one surface (e.g., a lower surface) of the base layer BS facing the substrate SUB. For example, the first bump control signal line BSL1 and the bump connection line BCL may be arranged under the base layer BS.

A third insulating layer IL3 may be arranged under the first bump control signal line BSL1 and the bump connection line BCL. The third insulating layer IL3 may cover the first bump control signal line BSL1 and the bump connection line BCL on the one surface of the base layer BS.

In an embodiment, the control output bumps OB1a and OB1b may be arranged on the same layer as the dummy bumps DB1c and DB1d. For example, the control output bumps OB1a and OB1b and the dummy bumps DB1c and DB1d may be arranged under the third insulating layer IL3. In a plan view, the control output bumps OB1a and OB1b may respectively overlap the control output pads OP1a and OP1b, and the dummy bumps DB1c and DB1d may respectively overlap the dummy pads DP1c and DP1d.

The first bump control signal line BSL1 may partially overlap the control output bump OB1a in a plan view. For example, a first end of the first bump control signal line BSL1 may overlap a first end of the control output bump OB1a in a plan view. A second end of the first bump control signal line BSL1 may be connected to the signal controller. The first bump control signal line BSL1 may be configured to receive the first control signal from the signal controller.

The third insulating layer IL3 may define a contact hole CTd exposing the first end of the first bump control signal line BSL1. For example, a portion of the third insulating layer IL3 may be removed to form the contact hole CTd. The first end of the control output bump OB1a may contact the first end of the first bump control signal line BSL1 through the contact hole CTd. Accordingly, the control output bump OB1a may be electrically connected to the first bump control signal line BSL1. Therefore, the first control signal may be transmitted to the control output bump OB1a.

The bump connection line BCL may partially overlap each of the control output bumps OB1a and OB1b in a plan view. For example, in a plan view, a first end of the bump connection line BCL may overlap a second end of the control output bump OB1a, and a second end of the bump connection line BCL may overlap a first end of the control output bump OB1b.

The third insulating layer IL3 may define a contact hole CTe exposing the first end of the bump connection line BCL and a contact hole CTf exposing the second end of the bump connection line BCL. For example, respective portions of the third insulating layer IL3 may be removed to form the contact holes CTe and CTf. The second end of the control output bump OB1a may contact the first end of the bump connection line BCL through the contact hole CTe. The first end of the control output bump OB1b may contact the second end of the bump connection line BCL through the contact hole CTf. Accordingly, the control output bumps OB1a and OB1b may be electrically connected to each other through the bump connection line BCL. Accordingly, the first control signal may be transmitted to the control output bump OB1b.

Each of the dummy bumps DB1c and DB1d is not electrically connected to the control output bumps OB1a and OB1b. For example, each of the dummy bumps DB1c and DB1d may be electrically floated.

A fourth insulating layer IL4 may be arranged under the control output bumps OB1a and OB1b and the dummy bumps DB1c and DB1d. The fourth insulating layer IL4 may define openings each exposing a central portion of each of the control output bumps OB1a and OB1b and the dummy bumps DB1c and DB1d.

The anisotropic conductive film ACF may be arranged between the display panel DPL and the driving chip DIC. The anisotropic conductive film ACF may include the resin layer RL and the conductive particles CP arranged in the resin layer RL.

The conductive particles CP may be arranged between the control output pad OP1a and the control output bump OB1a, between the control output pad OP1b and the control output bump OB1b, between the dummy pad DP1c and the dummy bump DB1c, and between the dummy pad DP1d and the dummy bump DB1d.

The control output pad OP1a and the control output bump OB1a may be electrically connected to each other through the conductive particles CP arranged between the control output pad OP1a and the control output bump OB1a. Accordingly, the first control signal may be transmitted from the control output bump OB1a to the control output pad OP1a.

The control output pad OP1b and the control output bump OB1b may be electrically connected to each other through the conductive particles CP arranged between the control output pad OP1b and the control output bump OB1b. Accordingly, the first control signal may be transmitted from the control output bump OB1b to the control output pad OP1b.

Even when the conductive film of the conductive particles CP arranged between the control output pad OP1a and the control output bump OB1a is lost and thereby the control output pad OP1a and the control output bump OB1a are electrically opened, the first control signal may be transmitted to the control output pad OP1b through the control output bump OB1b. The first control signal transmitted to the control output pad OP1b may be transmitted to the scan driver SDV or the emission driver EDV through the pad connection line PCL, the control output pad OP1a, and the first control signal line CSL1. Therefore, the reliability of the display device DD may be increased.

In an embodiment, a single control signal line (e.g., CSL1) is electrically connected to multiple control output pads (e.g., OP1a and OP1b) to ensure reliable signal transmission. For example, the first control signal is initially transmitted to control output pad OP1a, which in turn is connected to control output bump OB1a through conductive particles CP within the anisotropic conductive film ACF. However, if the conductive film of the CP between OP1a and OB1a degrades or is lost, causing an open circuit, the first control signal can still be transmitted through OP1b and OB1b as an alternative path. This redundancy is achieved by a pad connection line PCL that electrically connects OP1a and OP1b, ensuring that the first control signal reaching OP1b can continue to propagate. The signal from OP1b is then transmitted to the scan driver SDV or the emission driver EDV via the corresponding control signal line (e.g., CSL1), maintaining uninterrupted operation of the display device. By supporting one control signal line with two control output pads, the display device enhances signal integrity, prevents failures due to conductive particle degradation, and increased overall reliability without increasing circuit complexity. For further redundancy, multiple conductive particle CP may be present between a given control output bump and control output pad pair (e.g., OB1a and OP1a).

Because the dummy bumps DB1c and DB1d are each electrically floated, the corresponding dummy pads DP1c and DP1d may also be electrically floated.

The cross-sectional structures of the control output pad portion of the display panel DPL and the control output bump portion of the driving chip DIC about the first column 1C among the plurality of columns illustrated in FIG. 7 has been described above, and the above description may be similarly applied to other columns illustrated in FIG. 7.

Hereinafter, effects of the present embodiments will be explained referring to a simulation result of open risk of the control output pads and the control output bumps, according to comparative example and an embodiment.

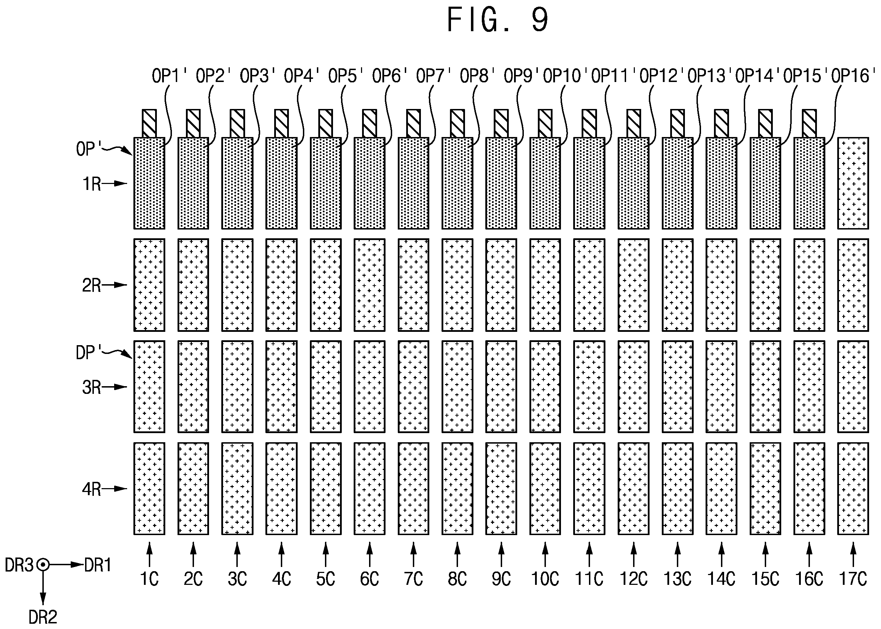

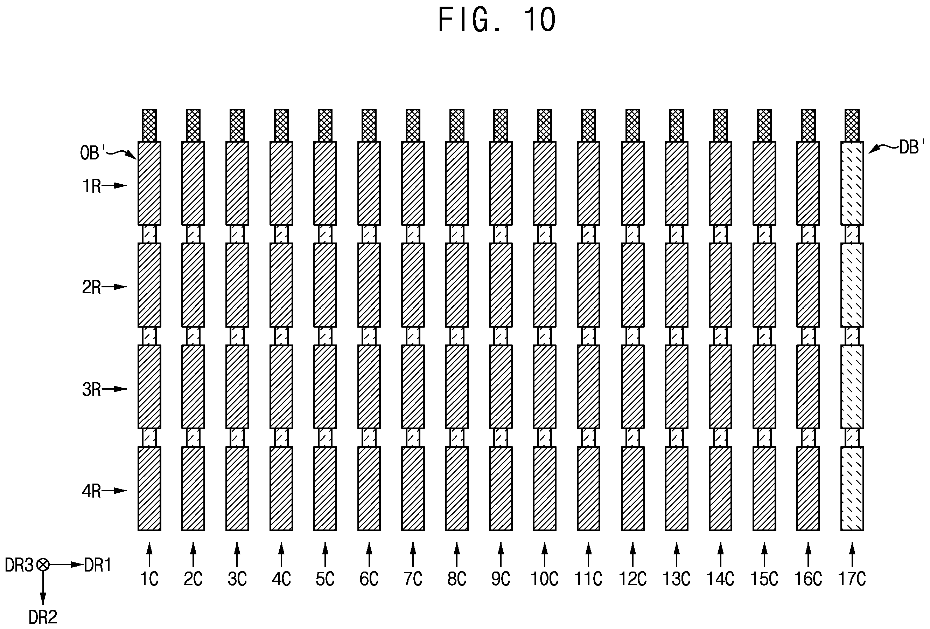

FIGS. 9 and 10 are views illustrating a control output pad portions and a control output bump portions according to a comparative example.

In the comparative example, control output pads OP', dummy pads DP', control output bumps OB', and dummy bumps DB' were arranged as illustrated in FIGS. 9 and 10. Specifically, in the comparative example, in each of the first to sixteenth columns 1C to 16C, the control output pads OP' were arranged only in the first row 1R, the control output pads OP' were not arranged in the second to fourth rows 2R to 4R, and only the dummy pads DP' were arranged in the second to fourth rows 2R to 4R. In addition, in the comparative example, in each of the first to sixteenth columns 1C to 16C, the control output bumps OB' were arranged in all of the first to fourth rows 1R to 4R, and the dummy bumps DB' were not arranged in all of the first to fourth rows 1R to 4R.

In the embodiment, the control output pads OP, the dummy pads DP, the control output bumps OB, and the dummy bumps DB were arranged as illustrated in FIGS. 5 and 6.

Table 1 is a table showing the simulation result of open risk (e.g., chance of an open) between the control output pad and the corresponding control output bump in each of the comparative example and the embodiment. Hereinafter, the open risk between the control output pad and the corresponding control output bump may be simply referred to as the open risk of the control output pad.

**[Table 1]**

| control signal | | comparative example | | embodiment | |
|---|---|---|---|---|---|
| name | duty ratio (%) | control output pad | open risk | control output pad | open risk |
| CS1 | 100 | OP1' | 0 | OP1b | 0 |
| CS2 | 100 | OP2' | 0.07 | OP2c | 0.01 |
| CS3 | 94 | OP3' | 0 | OP3d | 0.02 |
| CS4 | 100 | OP4' | 0.07 | OP4c | 0.11 |
| CS5 | 100 | OP5' | 0.14 | OP5b | 0.07 |
| CS6 | 88 | OP6' | 0.13 | OP6a | 0.13 |
| CS7 | 88 | OP7' | 0.25 | OP7b | 0.13 |
| CS8 | 88 | OP8' | 0.25 | OP8c | 0.13 |
| CS9 | 88 | OP9' | 0.51 | OP9d | 0.07 |
| CS10 | 64 | OP10' | 0.37 | OP10c | 0.16 |
| CS11 | 64 | OP11' | 0.57 | OP11b | 0.42 |
| CS12 | 63 | OP12' | 0.57 | OP12a | 0.57 |
| CS13 | 63 | OP13' | 0.57 | OP13b | 0.41 |
| CS14 | 64 | OP14' | 0.57 | OP14c | 0.35 |
| CS15 | 64 | OP15' | 1 | OP15d | 0.01 |
| CS16 | 6 | OP16' | 0.06 | OP16c | 0.02 |

In the comparative example and the embodiment, the first to sixteenth control signals CS1 to CS16 of Table 1 were respectively input to the first to sixteenth columns 1C to 16C. The first to sixteenth control signals CS1 to CS16 has the same high level and the same low level. The duty ratio of Table 1 means a width of a high period of each of the control signals.

Specifically, in Table 1, the open risks of the comparative example are simulated values of the open risk of each of the control output pads OP1', OP2', OP3', OP4', OP5', OP6', OP7', OP8', OP9', OP10', OP11', OP12', OP13', OP14', OP15', and OP16' of FIG. 9. The open risks of the embodiment are simulated values of the open risk of each of the outermost control output pads OP1b, OP2c, OP3d, OP4c, OP5b, OP6a, OP7b, OP8c, OP9d, OP10c, OP11b, OP12a, OP13b, OP14c, OP15d, and OP16 that furthest from the display area DA among the control output pads OP arranged in each of the control pad columns. In addition, the open risks of the comparative example and the embodiment in Table 1 were calculated as relative values when the open risk of the control output pad OP15', which is arranged in the first row 1R and the fifteenth column 15C and receive the fifteenth control signal CS15, is 1.

Referring to Table 1 and FIGS. 5, and 9, in the fifteenth column 15C in which the fifteenth control signal CS15 having the largest electric potential difference between adjacent control signals was input, it can be noted that the open risk of the control output pad OP15d according to the embodiment was significantly reduced compared to the open risk of the control output pad OP15' according to the comparative example. This is because, as illustrated in FIG. 5, the dummy pads DP electrically floated were arranged on both sides of the control output pads OP15d arranged in the fourth row 4R and the fifteenth column 15C. In addition, in other columns in which other control signals are input, it can be noted that the open risk of the control output pad according to the embodiment was reduced compared to the open risk of the control output pad according to the comparative example.

In a modified embodiment of FIG. 5, the control output pads OP are arranged in columns with varying numbers of pads, demonstrating that the invention is not limited to a triangular arrangement but may include other structured configurations. For example, in a first column, three control output pads OP1a, OP1b, and OP1c are positioned at different distances from the display area. In contrast, in a second column, only two control output pads OP2a and OP2b are provided. The arrangement continues in a manner similar to FIG. 5, where subsequent columns may contain different numbers of control output pads; for instance, a third column may include four control output pads OP3a, OP3b, OP3c, and OP3d, while a fourth column may include only one control output pad OP4a. Due to this variation in pad count per column, the outermost control output pads (i.e., those farthest from the display area) are positioned at different distances from the display area, resulting in a zigzag-like or staggered pattern in a plan view. Furthermore, the control output pads within each row are separated by dummy pads DP, with some rows containing more control output pads than others, leading to distinct groupings of control output pads across the pad area. While this embodiment presents one possible configuration, other embodiments may feature different arrangements, such as stepwise, irregular, or wave-like formations, depending on design requirements, pad distribution needs, and signal routing considerations.

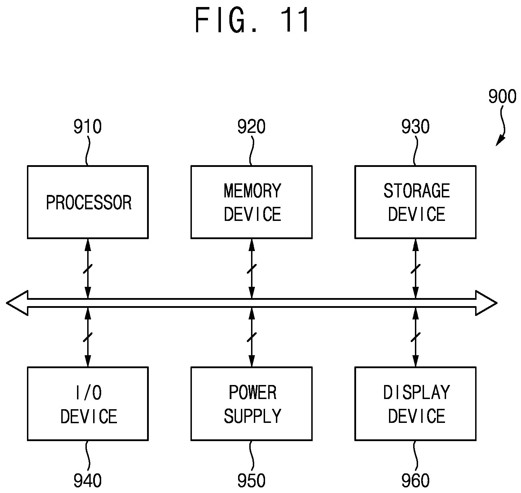

FIG. 11 is a block diagram illustrating an electronic device according to an embodiment.

Referring to FIG. 11, in an embodiment, an electronic device 900 may include a processor 910, a memory device 920, a storage device 930, an input/output ("I/O") device 940, a power supply 950, and a display device 960. Here, the display device 960 may correspond to the display device DD of FIG. 1. The electronic device 900 may further include a plurality of ports for communicating with a video card, a sound card, a memory card, a universal serial bus ("USB") device, or the like. In an embodiment, the electronic device 900 may be implemented as a television. In another embodiment, the electronic device 900 may be implemented as a smart phone. However, embodiments are not limited thereto, in another embodiment, the electronic device 900 may be implemented as a cellular phone, a video phone, a smart pad, a smart watch, a tablet personal computer ("PC"), a car navigation system, a computer monitor, a laptop, a head disposed (e.g., mounted) display ("HMD"), or the like.

The processor 910 may perform various computing functions. In an embodiment, the processor 910 may be a microprocessor, a central processing unit ("CPU"), an application processor ("AP"), or the like. The processor 910 may be coupled to other components via an address bus, a control bus, a data bus, or the like. In an embodiment, the processor 910 may be coupled to an extended bus such as a peripheral component interconnection ("PCI") bus.

The memory device 920 may store data for operations of the electronic device 900. In an embodiment, the memory device 920 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like, and/or at least one volatile memory device such as a dynamic random access memory ("DRAM") device, a static random access memory ("SRAM") device, a mobile DRAM device, or the like.

In an embodiment, the storage device 930 may include a solid state drive ("SSD") device, a hard disk drive ("HDD") device, a CD-ROM device, or the like. In an embodiment, the I/O device 940 may include an input device such as a keyboard, a keypad, a mouse device, a touchpad, a touch-screen, or the like, and an output device such as a printer, a speaker, or the like.

The power supply 950 may provide power for operations of the electronic device 900. The power supply 950 may be configured to provide a power to the display device 960. The display device 960 may be coupled to other components via the buses or other communication links. In an embodiment, the display device 960 may be included in the I/O device 940.

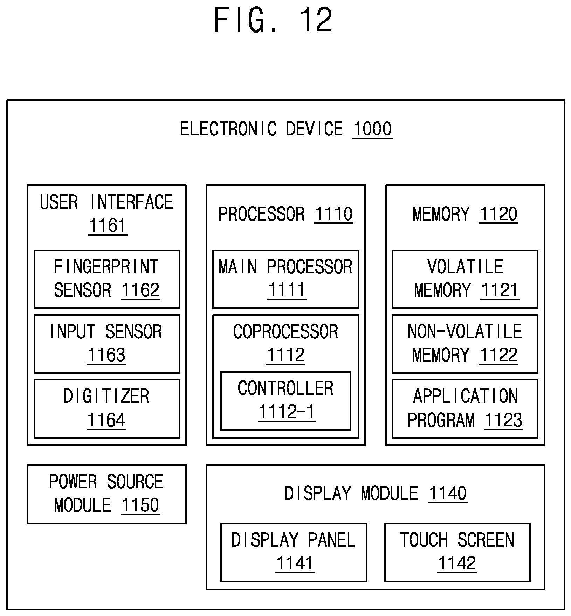

FIG. 12 is a diagram illustrating an electronic device according to an embodiment of the present invention. Referring to FIG. 12, the electronic device 1000 according to one embodiment of the present invention may output various information (e.g., images, text, music, etc.) through a display module 1140, which, for example, may correspond to the display device shown in FIG. 1. When a processor 1110 executes an application stored in a memory 1120, the display module 1140 may provide application information to a user through a display panel 1141.

In some embodiments, the electronic device 1000 may be configured as a smartphone, camera, smart TV, monitor, smartwatch, tablet, automotive display, or AR/VR headset. For example, the electronic device 1000 may be a smartphone including a touch-sensitive display area DA for interaction and a non-display area NDA including sensors and circuits for enhanced functionality. For example, the electronic device 1000 may be a television or monitor including a large display area DA for high-resolution video playback and a non-display area NDA incorporating driving circuits or connectivity modules for external inputs. For example, the electronic device 1000 may be a smartwatch including a display area DA optimized for compact and high-clarity visuals and a non-display area NDA integrating biometric sensors for health monitoring. In some cases, the electronic device 1000 be an AR/VR headset.

In some embodiments, memory 1120 may store information such as software codes for operating an application program 1123. The application program 1123 may include a software designed to execute specific tasks or provide functionality to a user. The application program 1123 may operate under the control of the processor 1110 and utilizes data stored in the memory 1120 to deliver a wide range of features, such as productivity tools, multimedia streaming and playback, file or mail deliveries or communication services. The application program 1123 interacts seamlessly with the user interface 1161 or touch screen 1142, allowing a user to launch, navigate, and utilize the program through user inputs such as touch, tap, gesture, or voice interaction.

Upon user selection of an application via touch screen 1142 or user interface 1161, the processor 1110 may execute the application program 1123 corresponding to the selected application retrieved from the memory 1120 to perform functionalities of the application. For example, when a user selects a camera application by tapping the icon (or a camera application icon) presented on the display panel 1141, the processor 1110 activates a camera module. The processor 1110 may transmit image data corresponding to a captured image acquired through the camera module to the display module 1140. The display module 1140 may display an image corresponding to the captured image through the display panel 1141.

As another example, when a user wishes to make a phone call, the user taps the telephone icon displayed on the display module 1140, the processor 1110 may execute a phone application program stored in the memory 1120. A telephone keypad may be presented on the display panel 1141 for the user to enter a phone number to call.

As another example, the display module 1140 may be integrated into an electronic device 1000, such as a laptop computer, smart TV, or tablet. A user wishing to access a multimedia streaming application (e.g., to watch a music video or movie) can do so by tapping the corresponding icon. This action activates the application, allowing the user to view the streamed content.

The processor 1110 may include a main processor 1111 and an auxiliary or coprocessor 1112. The main processor 1111 may include a central processing unit (CPU). The main processor 1111 may further include one or more of a graphics processing unit (GPU), a communication processor (CP), and an image signal processor (ISP).

The coprocessor 1112 may include a controller 1112-1. The controller 1112-1 may include an interface conversion circuit and a timing control circuit. The controller 1112-1 may receive an image signal from the main processor 1111, convert the data format of the image signal to match the interface specifications with the display module 1140, and output image data. The controller 1112-1 may output various control signals to drive the display module 1140. For example, the controller 1112-1 may drive the display module 1140 to display the icon on the display screen suitable for selection by a user to cause execution of an application program 1123.

The memory 1120 may store one or more application programs 1123 and various data used by at least one component (for example, the processor 1110 or the user interface 1161) of the electronic device 1000 and input data or output data for commands related thereto. For example, a camera application program, a GPS application program, an augmented reality and virtual reality application program, and other application programs that can be executed by the processor 1110 upon selection of corresponding icons presented on the display screen (or display panel 1141) via the touch screen 1142 or user interface 1161 by the user. In addition, various setting data corresponding to user settings may be stored in the memory 1120. The memory 1120 may include volatile memory 1121 and non-volatile memory 1122.

The display module 1140 may output visual information (images) to the user. The display module 1140 may include the display panel 1141, a gate driver, the source driver, a voltage generation circuit, and a touch screen 1142. The display module 1140 may further include a window, a chassis, and a bracket to protect the display panel 1141. The display module 1140 may include at least a part of the configuration of the display device shown in FIG. 1.

The user interface 1161 serves as the interaction medium between a user and the electronic device 1000. The user interface 1161 may detect an input by a part (e.g., finger) of a user's body or an input by a pen or a mouse, and generate an electric signal or data value corresponding to the input. The user interface 1161 includes the fingerprint sensor 1162, the input sensor 1163, and a digitizer 1164.

The fingerprint sensor 1162 may sense a fingerprint for biometric recognition of the user and may also measure one or more biological signals such as blood pressure, moisture, or body mass.

The input sensor 1163 may sense user interactions including touch, tap, gesture, motion, spoken command, and eye movement. The input sensor 1163 includes optical sensors for image capture, eye tracking, or motion and gesture detection. Optical sensors may be infrared or semiconductor photodetectors. The input sensor 1163 includes audio and acoustic sensors, which may be MEMS microphones for voice recognition or sound-based interaction. The audio and acoustic sensors can be installed as part of the user interface 1161 or embedded in the display panel 1141.

The digitizer 1164 may generate a data value corresponding to coordinate information of input by a pen or a mouse to control movement of an onscreen cursor. The digitizer 1164 may generate the amount of change in electromagnetic due to the input as the data value. The digitizer 1164 may detect an input by a passive pen or transmit and receive data with an active pen or a remote.

At least one of the fingerprint sensor 1162, the input sensor 1163, or the digitizer 1164 may be implemented as a sensor layer formed on the top layer of the display panel 1141 through a continuous process with a process of forming elements (for example, the light emitting element, the transistor, and the like) included in the display panel 1141.

In addition, the user interface 1161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera may be particularly suitable for AR/VR headset functions.

The touch screen 1142 includes touch sensors embedded in semiconductor layers of the display panel 1141 to sense pressure applied to the top layer (screen) of the display panel 1141. The touch sensors can be a capacitive or a resistive type. The touch screen 1142 may serve as the primary interface for the user to select and navigate applications, control, and interact with the electronic device 1000.

The display panel 1141 (or display) may include a liquid crystal display panel, an organic light emitting display panel, or an inorganic light emitting display panel, and the type of the display panel 1141 is not particularly limited. The display panel 1141 may be of a rigid type or a flexible type that can be rolled or folded. The display module 1140 may further include a supporter, bracket, heat dissipation member, and the like that support the display panel 1141. The display panel 1141 may include the display unit shown in FIG. 1.

The power source module 1150 may supply power to the components of the electronic device 1000. The power source module 1150 may include a battery that charges the power source voltage. The battery may include a non-rechargeable primary battery or a rechargeable secondary battery or fuel cell. The power source module 1150 may include a power management integrated circuit (PMIC). The PMIC may supply optimized power source to each of the components described above including the display module 1140.

Although embodiments and implementations have been described herein, other embodiments and modifications will be apparent from this description. Accordingly, the invention is not limited to such embodiments, but rather to the broader scope of the appended claims which defined the present invention.

## Claims

1. A driving chip (DIC) comprising:
a base layer (BS);
data output bumps (DOB) arranged on one surface of the base layer (BS), each of the data output bumps (DOB) being configured to transfer one of a plurality of data voltages; and
control output bumps (OB) arranged on the one surface of the base layer (BS), each of the control output bumps (OB) being configured to transfer one of a plurality of control signals, and
**characterized in that**
a number of the control output bumps (OB) configured to transfer a first control signal among the control signals is different from a number of control output bumps (OB) configured to transfer a second control signal among the control signals.

2. The driving chip (DIC) of claim 1, further comprising:
dummy bumps (DB) arranged on the one surface of the base layer (BS), adjacent to the control output bumps (OB), and electrically floated.

3. A display device (DD) comprising:
a substrate (SUB) including a display area (DA) and a non-display area (NDA) including a pad area (PDA) located on one side of the display area (DA);
pixels (PX) arranged in the display area (DA);
a driver circuit arranged in the non-display area (NDA);
a driving chip (DIC) overlapping the pad area (PDA) and configured to generate data voltages for the pixels (PX) and control signals for the driver circuit;
data output pads (DOP) arranged in the pad area (PDA), each of the data output pads (DOP) being configured to receive one of the data voltages; and
control output pads (OP) arranged in the pad area (PDA), each of the control output pads (OP) being configured to receive one of the control signals, and
wherein a number of the control output pads (OP) configured to receive a first control signal among the control signals is different from a number of the control output pads (OP) configured to receive a second control signal among the control signals.

4. The display device (DD) of claim 3, further comprising:
dummy pads (DP) arranged in the pad area (PDA), adjacent to the control output pads (OP), and electrically floated.

5. The display device (DD) of claim 4, wherein the control output pads (OP) and the dummy pads (DP) are arranged in a plurality of rows (R) and a plurality of columns (C), and
wherein the number of the control output pads (OP) arranged in a first row (1R) closest to the display area (DA) among the plurality of rows (R) is different from the number of the control output pads (OP) arranged in a n-th row (nR) among the plurality of rows (R), where n is a natural number greater than or equal to 2.

6. The display device (DD) of claim 5,
wherein the number of the control output pads (OP) arranged in the first row (1R) is greater than the number of the control output pads (OP) arranged in the n-th row (nR); and/or
wherein the number of the dummy pads (DP) arranged in the first row (1R) is different from or less than the number of the dummy pads (DP) arranged in the n-th row (nR).

7. The display device (DD) of claim 5 or 6, further comprising:
control signal lines (CSL) electrically connected to the control output pads (OP) arranged in the first row (1R), respectively, and
wherein each of the control signal lines (CSL) is electrically connected to the driver circuit.

8. The display device (DD) of any one of claims 5 to 7, wherein the control output pads (OP) arranged in each of the plurality of columns (C) are electrically connected to each other.

9. The display device (DD) of any one of claims 5 to 8, wherein the number of the control output pads (OP) arranged in a k-th column (kC) among the plurality of columns (C) is different from the number of the control output pads (OP) arranged in a p-th column (pC) among the plurality of columns (C), where k is a natural number greater than or equal to 2 and p is a natural number greater than or equal to 3 and is different from k.

10. The display device (DD) of claim 9, wherein the control output pads (OP) arranged in a (k-1)-th column ((k-1)C) are configured to receive a (k-1)-th control signal,
wherein the control output pads (OP) arranged in the k-th column (kC) are configured to receive a k-th control signal,
wherein the control output pads (OP) arranged in a (k+1)-th column ((k+1)C) are configured to receive a (k+1)-th control signal,
wherein the control output pads (OP) arranged in a (p-1)-th column ((p-1)C) are configured to receive a (p-1)-th control signal,
wherein the control output pads (OP) arranged in the p-th column (pC) are configured to receive a p-th control signal,
wherein the control output pads (OP) arranged in a (p+1)-th column ((p+1)C) are configured to receive a (p+1)-th control signal,
wherein a sum of an electric potential difference between the (k-1)-th control signal and the k-th control signal and an electric potential difference between the k-th control signal and the (k+1)-th control signal is greater than a sum of an electric potential difference between the (p-1)-th control signal and the p-th control signal and an electric potential difference between the p-th control signal and the (p+1)-th control signal, and
wherein the number of the control output pads (OP) arranged in the k-th column (kC) is greater than the number of the control output pads (OP) arranged in the p-th column (pC).

11. The display device (DD) of claim 10, wherein the number of the control output pads (OP) configured to receive the k-th control signal is greater than the number of the control output pads (OP) configured to receive p-th control signal; and/or
wherein the number of the dummy pads (DP) arranged in the k-th column (kC) is less than the number of the dummy pads (DP) arranged in the p-th column (pC); and/or
wherein a sum of the number of the control output pads (OP) arranged in the k-th column (kC) and the number of the dummy pads (DP) arranged in the k-th column (kC) is equal to a sum of the number of the control output pads (OP) arranged in the p-th column (pC) and the number of the dummy pads (DP) arranged in the p-th column (pC).

12. The display device (DD) of any one of claims 5 to 11,
wherein in each of the plurality of columns (C), at least one of the dummy pads (DP) is spaced apart from the display area (DA) with at least one of the control output pads (OP) interposed therebetween; and/or
wherein the outermost control output pads (OP) in each of the plurality of columns (C) are arranged in a zigzag pattern in a plan view, and
wherein each of the outermost control output pads (OP) is the control output pad (OP) positioned farthest from the display area (DA) within its respective column (C).

13. The display device (DD) of any one of claims 4 to 12, wherein the driving chip (DIC) comprises:
data output bumps (DOB) respectively overlapping the data output pads (DOP) and respectively electrically connected to the data output pads (DOP);
control output bumps (OB) respectively overlapping the control output pads (OP) and respectively electrically connected to the control output pads (OP); and
floating dummy bumps (DB) respectively overlapping the dummy pads (DP) and electrically floated.

14. The display device (DD) of claim 13, further comprising:
an anisotropic conductive film (ACF) arranged between the control output pads (OP) and the control output bumps (OB), and respectively electrically connecting the control output pads (OP) and the control output bumps (OB).

15. An electronic device (900, 1000) comprising:
a display device (DD) of any one of claims 3 to 14 configured to display an image; and
a power supply (950, 1150) configured to provide power to the display device (DD).

## Patentansprüche

1. Ansteuerungschip (DIC) umfassend:
eine Basisschicht (BS);
Datenausgangs-Bumps (DOB), die auf einer Fläche der Basisschicht (BS) angeordnet sind, wobei jeder der Datenausgangs-Bumps (DOB) dazu konfiguriert ist, eine aus einer Vielzahl von Datenspannungen zu übertragen; und
Steuerausgangs-Bumps (OB), die auf der einen Fläche der Basisschicht (BS) angeordnet sind, wobei jeder der Steuerausgangs-Bumps (OB) dazu konfiguriert ist, eines aus einer Vielzahl von Steuersignalen zu übertragen, und
**dadurch gekennzeichnet, dass** sich eine Anzahl der Steuerausgangs-Bumps (OB), die dazu konfiguriert sind, ein erstes Steuersignal unter den Steuersignalen zu übertragen, von einer Anzahl von Steuerausgangs-Bumps (OB), die dazu konfiguriert sind, ein zweites Steuersignal unter den Steuersignalen zu übertragen, unterscheidet.

2. Ansteuerungschip (DIC) nach Anspruch 1, ferner umfassend:
Dummy-Bumps (DB), die auf der einen Fläche der Basisschicht (BS), benachbart zu den Steuerausgangs-Bumps (OB), angeordnet und elektrisch potenzialfrei sind.

3. Anzeigevorrichtung (DD), umfassend:
ein Substrat (SUB), das einen Anzeigebereich (DA) und einen Nichtanzeigebereich (NDA) beinhaltet, und einen Pad-Bereich (PDA) beinhaltet, der sich auf einer Seite des Anzeigebereichs (DA) befindet;
Pixel (PX), die in dem Anzeigebereich (DA) angeordnet sind;
eine Treiberschaltung, die in dem Nichtanzeigebereich (NDA) angeordnet ist;
einen Ansteuerungschip (DIC), der den Pad-Bereich (PDA) überlappt und dazu konfiguriert ist, Datenspannungen für die Pixel (PX) und Steuersignale für die Treiberschaltung zu erzeugen;
Datenausgangs-Pads (DOP), die in dem Pad-Bereich (PDA) angeordnet sind, wobei jedes der Datenausgangs-Pads (DOP) dazu konfiguriert ist, eine der Datenspannungen zu empfangen; und
Steuerausgangs-Pads (OP), die in dem Pad-Bereich (PDA) angeordnet sind, wobei jedes der Steuerausgangs-Pads (OP) dazu konfiguriert ist, eines der Steuersignale zu empfangen, und
wobei sich eine Anzahl der Steuerausgangs-Pads (OP), die dazu konfiguriert sind, ein erstes Steuersignal unter den Steuersignalen zu empfangen, von einer Anzahl der Steuerausgangs-Pads (OP), die dazu konfiguriert sind, ein zweites Steuersignal unter den Steuersignalen zu empfangen, unterscheidet.

4. Anzeigevorrichtung (DD) nach Anspruch 3, ferner umfassend:
Dummy-Pads (DP), die in dem Pad-Bereich (PDA), benachbart zu den Steuerausgangs-Pads (OP), angeordnet und elektrisch potenzialfrei sind.

5. Anzeigevorrichtung (DD) nach Anspruch 4, wobei die Steuerausgangs-Pads (OP) und die Dummy-Pads (DP) in einer Vielzahl von Zeilen (R) und einer Vielzahl von Spalten (C) angeordnet sind, und
wobei sich die Anzahl der Steuerausgangs-Pads (OP), die in einer ersten Zeile (1R) unter der Vielzahl von Zeilen (R), die dem Anzeigebereich (DA) am nächsten liegt, angeordnet sind, von der Anzahl der Steuerausgangs-Pads (OP), die in einer n-ten Zeile (nR) unter der Vielzahl von Zeilen (R) angeordnet sind, unterscheidet, wobei n eine natürliche Zahl größer oder gleich 2 ist.

6. Anzeigevorrichtung (DD) nach Anspruch 5,
wobei die Anzahl der Steuerausgangs-Pads (OP), die in der ersten Zeile (1R) angeordnet sind, größer ist als die Anzahl der Steuerausgangs-Pads (OP), die in der n-ten Zeile (nR) angeordnet sind; und/oder
wobei sich die Anzahl der Dummy-Pads (DP), die in der ersten Zeile (1R) angeordnet sind, von der Anzahl der Dummy-Pads (DP), die in der n-ten Zeile (nR) angeordnet sind, unterscheidet oder kleiner als diese ist.

7. Anzeigevorrichtung (DD) nach Anspruch 5 oder 6, ferner umfassend:
Steuersignalleitungen (CSL), die jeweils elektrisch mit den in der ersten Zeile (1R) angeordneten Steuerausgangs-Pads (OP) verbunden sind, und
wobei jede der Steuersignalleitungen (CSL) elektrisch mit der Treiberschaltung verbunden ist.

8. Anzeigevorrichtung (DD) nach einem der Ansprüche 5 bis 7, wobei die Steuerausgangs-Pads (OP), die in jeder der Vielzahl von Spalten (C) angeordnet sind, elektrisch miteinander verbunden sind.

9. Anzeigevorrichtung (DD) nach einem der Ansprüche 5 bis 8, wobei sich die Anzahl der Steuerausgangs-Pads (OP), die in einer k-ten Spalte (kC) unter der Vielzahl von Spalten (C) angeordnet sind, von der Anzahl der Steuerausgangs-Pads (OP) unterscheidet, die in einer p-ten Spalte (pC) unter der Vielzahl von Spalten (C) angeordnet sind, wobei k eine natürliche Zahl größer oder gleich 2 ist und p eine natürliche Zahl größer oder gleich 3 ist und sich von k unterscheidet.

10. Anzeigevorrichtung (DD) nach Anspruch 9, wobei die Steuerausgangs-Pads (OP), die in einer (k-1)-ten Spalte ((k-1)C) angeordnet sind, dazu konfiguriert sind, ein (k-1)-tes Steuersignal zu empfangen,
wobei die Steuerausgangs-Pads (OP), die in der k-ten Spalte (kC) angeordnet sind, dazu konfiguriert sind, ein k-tes Steuersignal zu empfangen,
wobei die Steuerausgangs-Pads (OP), die in einer (k+1)-ten Spalte ((k+1)C) angeordnet sind, dazu konfiguriert sind, ein (k+1)-tes Steuersignal zu empfangen,
wobei die Steuerausgangs-Pads (OP), die in einer (p-1)-ten Spalte ((p-1)C) angeordnet sind, dazu konfiguriert sind, ein (p-1)-tes Steuersignal zu empfangen,
wobei die Steuerausgangs-Pads (OP), die in der p-ten Spalte (pC) angeordnet sind, dazu konfiguriert sind, ein p-tes Steuersignal zu empfangen,
wobei die Steuerausgangs-Pads (OP), die in einer (p+1)-ten Spalte ((p+1)C) angeordnet sind, dazu konfiguriert sind, ein (p+1)-tes Steuersignal zu empfangen,
wobei eine Summe aus einer elektrischen Potenzialdifferenz zwischen dem (k-1)-ten Steuersignal und dem k-ten Steuersignal und einer elektrischen Potenzialdifferenz zwischen dem k-ten Steuersignal und dem (k+1)-ten Steuersignal größer ist als eine Summe aus einer elektrischen Potenzialdifferenz zwischen dem (p-1)-ten Steuersignal und dem p-ten Steuersignal und einer elektrischen Potenzialdifferenz zwischen dem p-ten Steuersignal und dem (p+1)-ten Steuersignal, und
wobei die Anzahl der Steuerausgangs-Pads (OP), die in der k-ten Spalte (kC) angeordnet sind, größer ist als die Anzahl der Steuerausgangs-Pads (OP), die in der p-ten Spalte (pC) angeordnet sind.

11. Anzeigevorrichtung (DD) nach Anspruch 10, wobei die Anzahl der Steuerausgangs-Pads (OP), die dazu konfiguriert sind, das k-te Steuersignal zu empfangen, größer ist als die Anzahl der Steuerausgangs-Pads (OP), die dazu konfiguriert sind, das p-te Steuersignal zu empfangen; und/oder
wobei die Anzahl der Dummy-Pads (DP), die in der k-ten Spalte (kC) angeordnet sind, kleiner ist als die Anzahl der Dummy-Pads (DP), die in der p-ten Spalte (pC) angeordnet sind; und/oder
wobei eine Summe aus der Anzahl der Steuerausgangs-Pads (OP), die in der k-ten Spalte (kC) angeordnet sind, und der Anzahl der Dummy-Pads (DP), die in der k-ten Spalte (kC) angeordnet sind, gleich einer Summe aus der Anzahl der Steuerausgangs-Pads (OP), die in der p-ten Spalte (pC) angeordnet sind, und der Anzahl der Dummy-Pads (DP), die in der p-ten Spalte (pC) angeordnet sind, ist.

12. Anzeigevorrichtung (DD) nach einem der Ansprüche 5 bis 11,
wobei in jeder der Vielzahl von Spalten (C) mindestens eines der Dummy-Pads (DP) von dem Anzeigebereich (DA) beabstandet ist, wobei mindestens eines der Steuerausgangs-Pads (OP) dazwischen angeordnet ist; und/oder
wobei die äußersten Steuerausgangs-Pads (OP) in jeder der Vielzahl von Spalten (C) in einer Draufsicht in einem Zickzackmuster angeordnet sind, und
wobei jedes der äußersten Steuerausgangs-Pads (OP) das Steuerausgangs-Pad (OP) ist, das innerhalb seiner jeweiligen Spalte (C) am weitesten von dem Anzeigebereich (DA) entfernt positioniert ist.

13. Anzeigevorrichtung (DD) nach einem der Ansprüche 4 bis 12, wobei der Ansteuerungschip (DIC) Folgendes umfasst:
Datenausgangs-Bumps (DOB), die jeweils die Datenausgangs-Pads (DOP) überlappen und jeweils elektrisch mit den Datenausgangs-Pads (DOP) verbunden sind;
Steuerausgangs-Bumps (OB), die jeweils die Steuerausgangs-Pads (OP) überlappen und jeweils elektrisch mit den Steuerausgangs-Pads (OP) verbunden sind; und
potenzialfreie Dummy-Bumps (DB), die jeweils die Dummy-Pads (DP) überlappen und elektrisch potenzialfrei sind.

14. Anzeigevorrichtung (DD) nach Anspruch 13, ferner umfassend:
eine anisotrope leitfähige Folie (ACF), die zwischen den Steuerausgangs-Pads (OP) und den Steuerausgangs-Bumps (OB) angeordnet ist und die Steuerausgangs-Pads (OP) und die Steuerausgangs-Bumps (OB) jeweils elektrisch verbindet.

15. Elektronische Vorrichtung (900, 1000), umfassend:
eine Anzeigevorrichtung (DD) nach einem der Ansprüche 3 bis 14, die dazu konfiguriert ist, ein Bild anzuzeigen; und
eine Stromversorgung (950, 1150), die dazu konfiguriert ist, die Anzeigevorrichtung (DD) mit Strom zu versorgen.

## Revendications

1. Puce d'attaque (DIC), comportant :
une couche de base (BS) ;
des bosses de sortie de données (DOB) agencées sur une surface de la couche de base (BS), chacune des bosses de sortie de données (DOB) étant configurée pour transférer l'une d'une pluralité de tensions de données ; et
des bosses de sortie de commande (OB) agencées sur la surface de la couche de base (BS), chacune des bosses de sortie de commande (OB) étant configurée pour transférer l'un d'une pluralité de signaux de commande, et
**caractérisée en ce que**
un nombre des bosses de sortie de commande (OB) configurées pour transférer un premier signal de commande parmi les signaux de commande est différent d'un nombre de bosses de sortie de commande (OB) configurées pour transférer un deuxième signal de commande parmi les signaux de commande.

2. Puce d'attaque (DIC) selon la revendication 1, comportant en outre :
des bosses factices (DB) agencées sur la surface de la couche de base (BS), adjacentes aux bosses de sortie de commande (OB), et flottantes électriquement.

3. Dispositif d'affichage (DD) comportant :
un substrat (SUB) comportant une zone d'affichage (DA) et une zone de non-affichage (NDA) comportant une zone de pastilles (PDA) située d'un côté de la zone d'affichage (DA) ;
des pixels (PX) agencés dans la zone d'affichage (DA) ;
un circuit d'attaque agencé dans la zone de non-affichage (NDA) ;
une puce d'attaque (DIC) chevauchant la zone de pastilles (PDA) et configurée pour générer des tensions de données pour les pixels (PX) et des signaux de commande pour le circuit d'attaque ;
des pastilles de sortie de données (DOP) agencées dans la zone de pastilles (PDA), chacune des pastilles de sortie de données (DOP) étant configurée pour recevoir l'une des tensions de données ; et
des pastilles de sortie de commande (OP) agencées dans la zone de pastilles (PDA), chacune des pastilles de sortie de commande (OP) étant configurée pour recevoir l'un des signaux de commande, et
dans lequel un nombre des pastilles de sortie de commande (OP) configurées pour recevoir un premier signal de commande parmi les signaux de commande est différent d'un nombre des pastilles de sortie de commande (OP) configurées pour recevoir un deuxième signal de commande parmi les signaux de commande.

4. Dispositif d'affichage (DD) selon la revendication 3, comportant en outre :
des pastilles factices (DP) agencées dans la zone de pastilles (PDA), adjacentes aux pastilles de sortie de commande (OP), et flottantes électriquement.

5. Dispositif d'affichage (DD) selon la revendication 4, dans lequel les pastilles de sortie de commande (OP) et les pastilles factices (DP) sont agencées en une pluralité de rangées (R) et en une pluralité de colonnes (C), et
dans lequel le nombre des pastilles de sortie de commande (OP) agencées dans une première rangée (1R) la plus proche de la zone d'affichage (DA) parmi la pluralité de rangées (R) est différent du nombre des pastilles de sortie de commande (OP) agencées dans une nième rangée (nR) parmi la pluralité de rangées (R), n étant un nombre naturel supérieur ou égal à 2.

6. Dispositif d'affichage (DD) selon la revendication 5,
dans lequel le nombre des pastilles de sortie de commande (OP) agencées dans la première rangée (1R) est supérieur au nombre des pastilles de sortie de commande (OP) agencées dans la nième rangée (nR) ; et/ou
dans lequel le nombre des pastilles factices (DP) agencées dans la première rangée (1R) est différent ou inférieur au nombre des pastilles factices (DP) agencées dans la nième rangée (nR).

7. Dispositif d'affichage (DD) selon la revendication 5 ou 6, comportant en outre :
des lignes de signal de commande (CSL) connectées électriquement aux pastilles de sortie de commande (OP) agencées dans la première rangée (1R), respectivement, et
dans lequel chacune des lignes de signal de commande (CSL) est électriquement connectée au circuit d'attaque.

8. Dispositif d'affichage (DD) selon l'une quelconque des revendications 5 à 7, dans lequel les pastilles de sortie de commande (OP) agencées dans chacune de la pluralité de colonnes (C) sont connectées électriquement entre elles.

9. Dispositif d'affichage (DD) selon l'une quelconque des revendications 5 à 8, dans lequel le nombre des pastilles de sortie de commande (OP) agencées dans une k-ième colonne (kC) parmi la pluralité de colonnes (C) est différent du nombre des pastilles de sortie de commande (OP) agencées dans une p-ième colonne (pC) parmi la pluralité de colonnes (C), k étant un nombre naturel supérieur ou égal à 2 et p étant un nombre naturel supérieur ou égal à 3 et étant différent de k.

10. Dispositif d'affichage (DD) selon la revendication 9, dans lequel les pastilles de sortie de commande (OP) agencées dans une (k-1)-ième colonne ((k-1)C) sont configurées pour recevoir un (k-1)-ième signal de commande,
dans lequel les pastilles de sortie de commande (OP) agencées dans la k-ième colonne (kC) sont configurées pour recevoir un k-ième signal de commande,
dans lequel les pastilles de sortie de commande (OP) agencées dans une (k+1)-ième colonne ((k+1)C) sont configurées pour recevoir un (k+1)-ième signal de commande,
dans lequel les pastilles de sortie de commande (OP) agencées dans une (p-1)-ième colonne ((p-1)C) sont configurées pour recevoir un (p-1)-ième signal de commande,
dans lequel les pastilles de sortie de commande (OP) agencées dans la p-ième colonne (pC) sont configurées pour recevoir un p-ième signal de commande,
dans lequel les pastilles de sortie de commande (OP) agencées dans une (p+1)-ième colonne ((p+1)C) sont configurées pour recevoir un (p+1)-ième signal de commande,
dans lequel une somme d'une différence de potentiel électrique entre le (k-1)-ième signal de commande et le k-ième signal de commande et une différence de potentiel électrique entre le k-ième signal de commande et le (k+1)-ième signal de commande est supérieure à une somme d'une différence de potentiel électrique entre le (p-1)-ième signal de commande et le p-ième signal de commande et une différence de potentiel électrique entre le p-ième signal de commande et le (p+1)-ième signal de commande, et
dans lequel le nombre des pastilles de sortie de commande (OP) agencées dans la k-ième colonne (kC) est supérieur au nombre des pastilles de sortie de commande (OP) agencées dans la p-ième colonne (pC).

11. Dispositif d'affichage (DD) selon la revendication 10, dans lequel le nombre de pastilles de sortie de commande (OP) configurées pour recevoir le k-ième signal de commande est supérieur au nombre des pastilles de sortie de commande (OP) configurées pour recevoir le p-ième signal de commande ; et/ou
dans lequel le nombre des pastilles factices (DP) agencées dans la k-ième colonne (kC) est inférieur au nombre des pastilles factices (DP) agencées dans la p-ième colonne (pC) ; et/ou
dans lequel une somme du nombre des pastilles de sortie de commande (OP) agencées dans la k-ième colonne (kC) et du nombre des pastilles factices (DP) agencées dans la k-ième colonne (kC) est égale à une somme du nombre des pastilles de sortie de commande (OP) agencées dans la p-ième colonne (pC) et du nombre des pastilles factices (DP) agencées dans la p-ième colonne (PC).

12. Dispositif d'affichage (DD) selon l'une quelconque des revendications 5 à 11,
dans lequel, dans chacune de la pluralité de colonnes (C), au moins l'une des pastilles factices (DP) est espacée de la zone d'affichage (DA) avec au moins l'une des pastilles de sortie de commande (OP) interposée entre elles ; et/ou
dans lequel les pastilles de sortie de commande (OP) les plus extérieures dans chacune de la pluralité de colonnes (C) sont agencées selon un motif en zigzag dans une vue en plan, et
dans lequel chacune des pastilles de sortie de commande (OP) les plus extérieures est la pastille de sortie de commande (OP) positionnée au plus loin de la zone d'affichage (DA) au sein de sa colonne (C) respective.

13. Dispositif d'affichage (DD) selon l'une quelconque des revendications 4 à 12, dans lequel la puce d'attaque (DIC) comporte :
des bosses de sortie de données (DOB) chevauchant respectivement les pastilles de sortie de données (DOP) et respectivement connectées électriquement aux pastilles de sortie de données (DOP) ;
des bosses de sortie de commande (OB) chevauchant respectivement les pastilles de sortie de commande (OP) et respectivement connectées électriquement aux pastilles de sortie de commande (OP) ; et
des bosses factices flottantes (DB) chevauchant respectivement les pastilles factices (DP) et flottantes électriquement.

14. Dispositif d'affichage (DD) selon la revendication 13, comportant en outre :
un film conducteur anisotrope (ACF) agencé entre les pastilles de sortie de commande (OP) et les bosses de sortie de commande (OB), et connectant électriquement et respectivement les pastilles de sortie de commande (OP) et les bosses de sortie de commande (OB).

15. Dispositif électronique (900, 1000) comportant :
un dispositif d'affichage (DD) selon l'une quelconque des revendications 3 à 14, configuré pour afficher une image ; et
une alimentation électrique (950, 1150) configurée pour alimenter le dispositif d'affichage (DD).
